# EUROPEAN PATENT APPLICATION

(11) **EP 4 839 067 A1**
(43) Date of publication of application: **11.11.2026**
(21) Application number: 25174143.5
(22) Date of filing: 05.05.2025
(51) Int. Cl.: H10K 30/40, H10K 30/57

(54) **A MULTI - JUNCTION PHOTOVOLTAIC ELEMENT COMPRISING A FIRST PEROVSKITE SUBCELL, A SECOND PEROVSKITE SUBCELL, AND AN ORGANIC SUBCELL**

(71) Applicant: Heliatek GmbH, 01139 Dresden (DE)
(72) Inventor: Pfeiffer, Martin, 01309 Dresden (DE); Le, Phuong, 01309 Dresden (DE); Levichkova, Marieta, 01309 Dresden (DE); Uhrich, Christian, 01309 Dresden (DE); Weiß, Andre, 01309 Dresden (DE)

(57) **Abstract**

The invention relates to a multi-junction photovoltaic element (100) with at least three subcells (10,20,30), comprising a front electrode (2), a back electrode (3), and a stack (50) arranged between the front electrode (2) and the back electrode (3), the stack (50) comprising the subcells (10,20,30) in a sequence from a side facing the light to a side facing away from the light as follows: a first perovskite subcell (10) comprising a first perovskite photoactive layer (14) having a first band-gap, the first perovskite photoactive layer (14) comprising at least one perovskite absorber material; a second perovskite subcell (20) comprising a second perovskite photoactive layer (24) having a second band-gap, the second perovskite photoactive layer (24) comprising at least one perovskite absorber material; and an organic subcell (30) comprising an organic photoactive layer (34) absorbing in the near-infrared (NIR) spectral range and having a third band-gap, the organic photoactive layer (34) comprising at least one donor and at least one acceptor forming a donor/acceptor heterojunction, wherein the first band-gap is larger than the second band-gap and the second band-gap is larger than the third band-gap.

## Description

The present invention relates to a multi-junction photovoltaic element comprising a first perovskite subcell, a second perovskite subcell, and an organic subcell absorbing in the near-infrared (NIR) spectral range, the organic photoactive layer comprising at least one donor and at least one acceptor forming a donor/acceptor heterojunction.

The power conversion efficiency (PCE) of perovskite solar cells (PSC) increased significantly during the last years. Perovskite solar cells have attracted increasing interest due to their photophysical properties as well as commercial applications. The total efficiency of perovskite single-junction and perovskite/perovskite tandem solar cells as well as perovskite/organic tandem solar cells still needs to be improved. This is in particular valid for solar cells manufactured by vacuum deposition which is scalable for large scale commercial production. Perovskite solar cells prepared by vacuum deposition have the potential to show improved durability compared to corresponding perovskite solar cells from solution processing.

The theoretical efficiency limit of a tandem- or multi-junction solar cell is higher than for a single junction solar cell (Shockley-Queisser-Limit), correspondingly, devices combining organic photovoltaic subcells with organic or inorganic subcells in a tandem- or multi-junction device were reported. In organic solar cells the subcell absorbing in the blue-green region is often limiting the overall photocurrent and efficiency (PCE). Combining perovskite subcells and organic subcells in a multi-junction device could be an effective approach to absorb radiation in a broad range of wavelengths.

Processing from solution has been the most accessible and predominant method enabling state-of-the-art laboratory scale perovskite solar cells. However, solution-processing techniques are less pertinent for the translation to large-area industrialscale fabrication due to costs, solvent procurement and servicelife of the perovskite solar cells, and the flexibility to grow multi-layer structures. Perovskite solar cells which are either processed from solution or only partially processed by vacuum deposition are complicating prospects of industrial upscaling and are affecting overall device stability.

Vacuum deposition is a well-established technique widely used in industrial semiconductor manufacturing such as for organic light emitting diodes (OLEDs) or light absorbing organic photovoltaic elements (OPVs), which illustrate prospects for commercial upscaling and large-scale production. Vacuum deposition allows strict control over of layer thickness, excellent uniformity and homogeneity of layers. Perovskite solar cells are mainly manufactured by solution-processing techniques but also vacuum deposition of perovskite solar cells is reported. The manufacturing of perovskite solar cells by vacuum deposition of perovskite solar cells usually involves the co-sublimation of at least two kinds of precursors in a vacuum chamber which together from the perovskite photoactive structure.

Highly efficient perovskite single-junction solar cells using perovskite materials comprising specific organic cations, i.e. methylammonium lead iodide (MAPI), formamidinium lead iodide (FAPI), are known from prior art and are usually prepared by using solution processes. Precursors for preparing inorganic perovskite photoactive layers comprising organic cations are generally vaporizable in a vacuum but are not useful in commercial production which require high deposition rates. There is no scalable vacuum process for inorganic perovskite comprising such organic cations available, which might improve the stability of perovskite layers compared to processing from solution. In contrast, inorganic perovskite materials of general formula CsPb(X:Y)₃ (X and Y = I or Br in different ration) show good processability in vacuum, however, the wide band-gap does not allow highly efficient single junction perovskites or tandem perovskites, e.g. the lowest band-gap of CsPBI₃ is 1.72 eV, showing no absorption in the red and near-infrared (NIR) wavelength range. Furthermore, tandem solar cells which are vaporizable based on a perovskite subcell and an organic subcell absorbing in the IR range are restricted by a low current generation of the organic subcell in its efficiency.

Solar cells comprising perovskite/perovskite tandem cells or organic/perovskite tandem cells are known.

Wang et al. (Recent progress and prospects of integrated perovskite/organic solar cells, Applied Physics Reviews, 7, 2020, 031303) discloses tandem solar cells which combine perovskite, silicon, copper indium gallium diselenide, quantum dots and organic solar cells in a multi-junction approach.

US 12,120,893 B2 discloses interconnecting structures for perovskite tandem solar cells comprising an ion-doped fullerene layer and a metal oxide layer. The tandem cell device employs organic-inorganic metal halide perovskites which are solutionprocessed.

Chiang et al. (ACS Energy Lett., 2023, 8, 2728-2737) discloses vacuum-deposited wide-bandgap perovskite for all-perovskite tandem solar cells based on organic perovskites comprising formamidinium or methylammonium.

Yuan et al. (ACS Appl. Mater. Interfaces, 2023, 15, 772-781) discloses thermally stable perovskite solar cells by all-vacuum deposition.

In organic/inorganic perovskite tandem cells formed by vacuum deposition the properties of organic cations, e.g. methylammonium or formamidinium, are difficult to be processed in vacuum limiting the viability of vacuum-deposited organic/inorganic perovskite solar cells. On the other hand, organic/inorganic perovskite solar cells degrade rapidly under thermal stress.

The relatively narrow light absorption region of perovskite and large open-circuit voltage loss of organic solar cells hinder further improvement of each kind of solar cells. Perovskite solar cells are limited in absorbing in the NIR range. Combined perovskite/organic solar cells comprising near-infrared (NIR) organic absorber materials enhance short-circuit current density while high open-circuit voltage of perovskite devices is reserved.

It is therefore an object of the present invention to provide a hybrid stack architecture of combined perovskite subcells and organic subcells which are processable by vacuum deposition, in particular under high-rate deposition, and which process in particular is scalable. It is further an object of the present invention to provide organic/perovskite hybrid solar cells which show increased efficiency (power conversion efficiency - PCE) compared to the respective perovskite cells and compared to the respective organic cells which are processable by vacuum deposition. Therefore, on the one hand the intensity of absorption must be improved and on the other hand the absorption spectrum broadened. The intrinsic durability of a hybrid stack architecture of combined perovskite subcells and organic subcells is at least not negatively affected or even improved.

The object is achieved by means of the subject-matter of the independent claims. Advantageous embodiments are evident from the dependent claims.

The object of the present invention is in particular solved by a multi-junction photovoltaic element with at least three subcells, comprising a front electrode, a back electrode, and a stack arranged between the front electrode and the back electrode, the stack comprising the subcells in a sequence from a side facing the light to a side facing away from the light as follows:
a first perovskite subcell comprising a first perovskite photoactive layer having a first band-gap, the first perovskite photoactive layer comprising at least one perovskite absorber material;
a second perovskite subcell comprising a second perovskite photoactive layer having a second band-gap, the second perovskite photoactive layer comprising at least one perovskite absorber material; and
an organic subcell comprising an organic photoactive layer absorbing in the red and near-infrared (NIR) spectral range and having a third band-gap, the organic photoactive layer comprising at least one donor and at least one acceptor forming a donor/acceptor heterojunction,
wherein the first band-gap is larger than the second band-gap and the second band-gap is larger than the third band-gap.

In the context of the present invention the front electrode of the photovoltaic element is located at a side of the photovoltaic element facing the light as intended.

The present invention is, in particular, focused on perovskite/organic-hybrid photovoltaic elements which are processable by vacuum deposition, in particular which are processed by vacuum deposition.

A multi-junction photovoltaic element is, in particular, a photovoltaic element comprising a stack of a vertical layer system of at least three subcells connected in series.

A band-gap, preferably an optical band-gap, is in particular understood to be an absorption onset, in particular a photon energy at which absorption onset occurs. A difference in a bandgap is in particular understood as a difference in the absorption onsets between two photoactive layers. In particular, an optical band gap is understood to be the photon energy at which the absorption spectrum of a material has a first inflection point.

In the context of the present invention, the first band-gap is a wide band-gap, in particular a band-gap having a larger energy gap between valence band and conduction band compared to a narrow band-gap. In the context of the present invention, the third bandgap is a narrow band-gap, in particular a band-gap having a smaller energy gap between valence band and conduction band compared to a wide band-gap. In the context of the present invention, the second band-gap is a mid band-gap, in particular a band-gap having a energy gap between valence band and conduction band which is larger compared to a narrow band-gap and smaller compared to a wide band-gap.

In the context of the present invention a photoactive layer is a layer which actively contributes as absorber layer by absorption of light and conversion into electrical energy. In this context the term photoactive is understood to mean the conversion of light energy to electrical energy, e.g. the photovoltaic element converts light energy into electrical energy, the photoactive layers being, in particular, light-absorbing layers.

In a preferred embodiment the front electrode is a transparent electrode, in particular the front electrode is arranged at a side of the photovoltaic element facing the light as intended and the back electrode is arranged at a side of the photovoltaic element facing away the light as intended.

In a preferred embodiment a metal oxide layer is arranged between the second perovskite photoactive layer and the back electrode. In a preferred embodiment the metal oxide layer is directly arranged at the back electrode. Preferably the work-function of the metal oxide layer is 5.0 eV to 7.0 eV (determined by UPS), preferably 5.5 eV to 7.0 eV, preferably 6.0 eV to 7.0 eV, or preferably 6.5 eV to 7.0 eV, and/or the material of the metal oxide layer is selected from the group consisting of CrOx, InOx, MoOx, NbOx, NiOx, SnOx, TiOx, VOx, WOx, and ZnOx, preferably the metal oxide layer is formed by mixtures of at least thereof.

The multi-junction photovoltaic element according to the present invention has advantages in comparison to the prior art. Advantageously, the efficiency of a perovskite photovoltaic element is increased by combining two perovskite subcells and an organic subcell to a multi-junction photovoltaic element. By combining properly a wide band-gap perovskite subcell, a mid bandgap perovskite subcell, and a narrow band-gap organic subcell into a multi-junction photovoltaic device a higher output photovoltage compared to perovskite subcells alone can be achieved without any detrimental effects on the short circuit current and fill factor, thus, the performance (PCE) of the photovoltaic element is enhanced. Advantageously, the absorption range is increased compared to perovskite single-junctions or perovskite tandem cells. Advantageously, the combination of a perovskite subcell and an organic subcell increases the power conversion efficiency (PCE) of a photovoltaic element. Furthermore, the durability of a multi-junction photovoltaic device is possibly affected by the stack architecture. Advantageously, the organic photoactive layer as well as the perovskite photoactive layers can be processed in vacuum. Multi-junctions according to the present invention in particular show improved efficiency (PCE) compared to vacuum processed organic tandem cells or triple-junctions, and inorganic perovskite single junctions or tandem cells.

According to a development of the invention, the organic photoactive layer having an absorption edge of at least 700 nm, preferably of at least 750 nm, preferably of at least 780 nm, or preferably of at least 800 nm.

According to a development of the invention, the first band-gap of the first perovskite photoactive layer is larger than the second band-gap of the second perovskite photoactive layer by at least 100 meV, preferably by at least 130 meV, preferably by at least 150 meV, or preferably by at least 200 meV, and/or the second band-gap of the second perovskite photoactive layer is larger than the third band-gap of the organic photoactive layer by at least 200 meV, preferably by at least 300 meV, each related on the absorption onset of the respective photoactive layer.

According to a development of the invention, the first band-gap of the first perovskite photoactive layer is a band-gap of at least 1.75 eV, preferably of at least 1.78 eV, preferably of at least 1.80 eV, or a band-gap in the range of 1.72 eV to 3.0 eV, preferably a band-gap in the range of 1.80 eV to 3.0 eV, and the second band-gap of the second perovskite photoactive layer is a band-gap of less than 1.80 eV, preferably of less than 1.75 eV, preferably of less than 1.72 eV, preferably of less than 1.70 eV, preferably of less than 1.65 eV, or preferably of less than 1.60 eV, or a band-gap in the range of 1.50 eV to 1.80 eV, preferably a band-gap in the range of 1.5 eV to 1.75 eV, preferably a band-gap in the range of 1.60 eV to 1.70 eV, and the third band-gap of the organic photoactive layer is a band-gap of less than 1.50 eV, preferably of less than 1.40 eV, preferably of less than 1.30 eV, or preferably of less than 1.20 eV, or a band-gap in the range of 0.7 eV to 1.6 eV, preferably a band-gap in the range of 0.7 eV to 1.5 eV, each related on the absorption onset of the respective photoactive layer.

According to a development of the invention, the first perovskite subcell, the second perovskite subcell, and/or the organic subcell each are formed as a nip cell comprising an n-type layer, an intrinsic photoactive layer, and a p-type layer, wherein in each subcell the n-type layer is at a side facing the light and the p-type layer is at a side facing away from the light, or wherein the first perovskite subcell is formed as an ip cell comprising an intrinsic photoactive layer and a p-type layer, wherein the intrinsic photoactive layer is at a side facing the light and the p-type layer is at a side facing away from the light, and the second perovskite subcell and/or the organic subcell each are formed as a nip cell comprising an n-type layer, an intrinsic photoactive layer, and a p-type layer, wherein in each subcell the n-type layer is at a side facing the light and the p-type layer is at a side facing away from the light. Preferably the intrinsic layer (i-layer) is an undoped layer which might be formed by a single material or a mixture of at least two materials.

In a preferred embodiment the p-type layer is a non-doped p-type layer, preferably hole transport material (HTM), and/or a doped p-type layer, preferably a hole transport material (HTM) and a p-dopant. Preferably the absolute value of the LUMO of the p-dopant is at least equal to the absolute value of the HOMO of the corresponding p-type layer minus 0.2 eV or larger to allow for efficient p-doping.

In a preferred embodiment the n-type layer is a non-doped n-type layer, preferably consisting of an electron transport material (ETM). In a more preferred embodiment the n-type layer consists of a fullerene or a fullerene derivative, preferably fullerene C60.

In a preferred embodiment, the fullerene or a fullerene derivative of the n-type layer is selected from the group consisting of C60, C70, C76, C80, C82, C84, C86, C90 und C94, or a derivative thereof, wherein the derivative preferably is a halogenated fullerene, a hydroxylated fullerene, a carboxylated fullerene, or an aminated fullerene, preferably the fullerene is C60, C70 and/or a derivative thereof, more preferably fullerene C60.

In an alternative preferred embodiment, the n-type layer is a n-doped n-type layer, preferably comprising an electron transport material (ETM) and an n-dopant. Preferably the absolute value of the HOMO of the n-dopant is at least equal to the absolute value of the LUMO of the corresponding n-type layer plus 0.2 eV or smaller to allow for efficient n-doping.

HOMO- and LUMO-energy levels can be determined from the redox potentials of the molecules, for which measurement methods are sufficiently described in the literature. The measurement by Cyclovoltammetry is described by Lucia Leonat et al. (U.P.B. Sci. Bull., Series B, Vol. 75, Iss. 3, 2013). Alternatively, HOMO and LUMO energies or the corresponding ionization energies and electron affinities can be determined from photoelectron spectroscopy and inverse photoelectron spectroscopy.

In a preferred embodiment the n-type layer is formed by an intrinsic n-type sublayer and an n-doped n-type sublayer, preferably the intrinsic n-type sublayer is directly arranged at the photoactive layer of the subcell. In a preferred embodiment the p-type layer is formed by an intrinsic p-type sublayer and a p-doped p-type sublayer, preferably the intrinsic n-type sublayer is directly arranged at the photoactive layer of the subcell.

According to a development of the invention, the organic subcell is formed as a BHJ, BHJ², BHJ+, PHJ, or PHJ-cascade cell. In the context of the present invention a BHJ (bulk-heterojunction) cell is an organic subcell comprising a donor-acceptor blended layer. In the context of the present invention a BHJ² cell is an organic subcell comprising two donor-acceptor blended layers directly attached to each other, wherein the two layers differ at least in the donor-material or the acceptor-material. In the context of the present invention, a BHJ+ cell is an organic subcell comprising a donor-acceptor blended layer and directly arranged at least one intrinsic donor or one intrinsic acceptor layer. In the context of the present invention a PHJ (planar heterojunction) cell is an organic subcell comprising an intrinsic acceptor layer and an intrinsic donor layer directly attached to each other. In the context of the present invention a PHJ-cascade cell is an organic subcell comprising an acceptor layer directly attached to at least two donor layers having different potentials, or a donor layer directly attached to at least two acceptor layers having different potentials.

According to a development of the invention, a passivation layer is arranged at a side facing the light of the first perovskite photoactive layer and/or at a side facing the light of the second perovskite photoactive layer, wherein preferably the passivation layer is a layer of Al₂O₃, InO₂, PbCl₂ PbI₂, PbI₃, SnO₂, or TiO₂, more preferably the passivation layer is a layer of PbCl₂ or SnO₂.

According to a development of the invention, the passivation layer has a layer thickness of 1 nm to 10 nm, or preferably of 1 nm to 5 nm.

In a preferred embodiment the first perovskite photoactive layer and the second perovskite photoactive layer are free of methylammonium lead iodide (MAPI) and formamidinium lead iodide (FAPI).

According to a development of the invention, the first perovskite photoactive layer and/or the second perovskite photoactive layer comprise organic cations at maximum of 20 wt.-% (weight%), preferably at maximum of 10 wt.-%, more preferably do not comprise organic cations, preferably the first perovskite photoactive layer comprises an inorganic layer as matrix material and/or the second perovskite photoactive layer comprises an inorganic layer as matrix material.

In a preferred embodiment, the first perovskite photoactive layer is an inorganic layer and/or the second perovskite photoactive layer is an inorganic layer.

In a preferred embodiment, the perovskite absorber material of the first photoactive layer is an inorganic perovskite, preferably an all-inorganic perovskite.

According to a development of the invention, the perovskite absorber material of the first perovskite photoactive layer and/or the second perovskite photoactive layer is independently an inorganic perovskite, preferably a three-dimensional halide perovskite, a double perovskite, or a combination thereof, wherein preferably the three-dimensional halide perovskite having a formula ABX₃, wherein A is selected from Cs, Na, K, Rb, or a combination thereof; B is selected from Pb, Sn, Ge, Cu, Fe, Ga, Eu, Sr, Ti, Mn, Bi, Zn, Mg, Ca, Ba, Y, Yb, Co, In, Sb, Bi, Ag, Ni, Ho, Er, Tb, Sm, La, or a combination thereof, preferably wherein A cations having an ionic radius smaller than Pb or Sn are present at less than 5 mol-% with respect to Pb or Sn; and X is selected from F, Cl, Br, I, or a combination thereof; and wherein preferably the double perovskite having a formula A₂BCX₆, wherein A is selected from Cs, Rb, or combination thereof; B is selected from Cu, Ag, Hg, Au, or a combination thereof; C is selected from Sb, Bi, In or a combination thereof; and X is selected from F, Cl, Br, I, or a combination thereof.

According to a development of the invention, the at least one perovskite absorber material in the first perovskite photoactive layer (14) is Cs_{y}Pb(IₓBr₍₁₋ₓ₎)₃ with x<0.75, preferably x<0.5, or preferably x<0.4, or in the range of 0.1 < x < 0.75, preferably in the range of 0.4 < x < 0.7, and y in the range of 0.9 < y < 1.1, and the at least one perovskite absorber material in the second perovskite photoactive layer (24) is Cs_{y}Pb(IₓBr₍₁₋ₓ₎)₃ with x>0.9, preferably with x>0.94, or in the range of 1.0 > x >0.9, preferably in the range of 1.0 > x >0.94, and with y in the range of 0.9 < y < 1.1.

In a preferred embodiment, the first perovskite photoactive layer and/or the second perovskite photoactive layer comprises Dimethylammonium iodide (DMAI) or Guanidinium iodide (GAI) as dopant.

According to a development of the invention, the perovskite absorber material of the first perovskite photoactive layer and/or the perovskite absorber material of the second perovskite photoactive layer is doped by PbCl₂, preferably in a ratio of 0.1 to 3 wt.-%, preferably 0.5 to 3 wt.-%, preferably 0.1 to 2 wt.-%, or preferably 0.5 to 2 wt.-%, or the perovskite absorber material of the first perovskite photoactive layer and/or the perovskite absorber material of the second perovskite photoactive layer is doped by an organic salt, preferably guanidinium halide (GAX), biguanidinium halide (BGAX), or metformine halide (MFX) with X selected from I, Br, or Cl, preferably in a ratio of 0.1 to 5 wt.-%, preferably 0.5 to 4 wt.-%, preferably 0.5 to 3 wt.-%, or preferably 1 to 3 wt.-%.

According to a development of the invention, the thickness of the first perovskite photoactive layer is 50 nm to 1000 nm, preferably 50 nm to 500 nm, preferably 50 nm to 300 nm, or preferably 100 nm to 400 nm, and/or the thickness of the second perovskite photoactive layer is 100 nm to 1000 nm, preferably 100 nm to 500 nm, preferably 100 nm to 300 nm, or preferably 200 nm to 400 nm, and/or the thickness of the organic photoactive layer is 5 nm to 50 nm, preferably 5 nm to 30 nm, or preferably 10 nm to 30 nm.

In a preferred embodiment the layer thickness of the second perovskite photoactive layer is larger than the layer thickness of the first perovskite photoactive layer, preferably larger by at least 10 nm, preferably by at least 20 nm, preferably by at least 50 nm, or preferably by at least 80 nm.

According to a development of the invention, the at least one donor of the organic photoactive layer is an A-D-A compound and/or a BODIPY compound, and/or the at least one acceptor of the organic photoactive layer is a fullerene or fullerene derivate, preferably fullerene C60.

In a preferred embodiment the at least one donor of the organic photoactive layer is a small molecule having a defined molecular structure and a molar mass of 100 g/mol to 1200 g/mol, preferably 100 g/mol to 1000 g/mol, or preferably 100 g/mol to 800 g/mol.

In the context of the present invention 'small molecules' are in particular understood to be non-polymeric organic molecules having a defined molecular structure and a defined molar mass. Such "small molecules" show ability to vaporize in vacuum and the associated possibility of purification by gradient sublimation, as one result layers comprising small molecules can be deposited by vacuum deposition.

According to a development of the invention, the p-type layer of each subcell is a doped and/or non-doped p-type layer having a band-gap of more than 2.5 eV, wherein the p-type layer has an ionization energy of at least 5.0 eV, and wherein the n-type layer of each subcell is a doped and/or non-doped n-type layer comprising an electron transport material (ETM) and at least one n-dopant, wherein the n-type layer has an electron affinity of less than 4.4 eV. In a preferred embodiment the ratio of the p-dopant in the doped p-type layer is 1 to 20 wt.-%, preferably 2 to 20 wt.-%. In a preferred embodiment the ratio of the n-dopant in the doped n-type layer is 1 to 20 wt.-%, preferably 2 to 20 wt.-%.

According to a development of the invention, between the first perovskite subcell and the second perovskite subcell, and/or between the second perovskite subcell and the organic subcell an n-doped interlayer is arranged, the n-doped interlayer comprising a matrix material, preferably an electron transport material (ETM), and at least one n-dopant, wherein the n-doped interlayer has an electron affinity of more than 4.4 eV, preferably the n-dopant of the n-doped interlayer has a HOMO more negative than - 4.6 eV, and wherein the ratio of the at least one dopant is 1 to 30 vol.-%.

In a preferred embodiment the n-dopant of the n-doped interlayer has a HOMO more negative than -4.8 eV, or preferably more negative than -5.0 eV.

In a preferred embodiment the n-doped interlayer has an electron affinity of more than 4.5 eV, preferably more than 4.6 eV, preferably more than 4.7 eV, preferably more than 4.8 eV, or preferably more than 4.9 eV, wherein preferably the ratio of the electron transport material in the n-doped interlayer is at maximum 98.5 vol.-%, preferably at maximum 98 vol.-%, preferably at maximum 97 vol.-%, preferably at maximum 96 vol.-%, or preferably at maximum 95 vol.-%.

In a preferred embodiment between the first perovskite photoactive layer and the second perovskite photoactive layer the p-type layer is facing the first perovskite photoactive layer and the n-type layer is facing the second perovskite photoactive layer, and between the second perovskite photoactive layer and the organic photoactive layer the p-type layer is facing the second perovskite photoactive layer and the n-type layer is facing the organic photoactive layer. Preferably an n-type layer is an electron transport layer which might be n-doped, and a p-type layer is a hole transport layer, which might be p-doped.

An interconnecting unit is understood to mean, in particular, a layer or a layer sequence between two photoactive layers, which connects the photoactive layers in series. By introducing the interconnecting unit, the stability of the photovoltaic element is increased. The interconnecting unit comprises a p-type layer and an n-type layer arranged between two photoactive layers, preferably the n-type layer is formed by an intrinsic n-type sublayer and/or an n-doped n-type sublayer, and/or the p-type layer is formed by an intrinsic p-type sublayer and/or a p-doped p-type sublayer.

In the context of the present invention a p-type layer of a subcell and a n-type layer of a following subcell are forming together an interconnecting unit. Preferably the interconnecting unit comprises the n-doped interlayer arranged between the n-type layer and the p-type layer, wherein preferably at least one intrinsic n-type sublayer and/or at least one intrinsic p-type sublayer is directly arranged at the first subcell and/or the second subcell.

In a preferred embodiment the interconnecting unit comprises in sequence the following layers: a) the doped and/or non-doped p-type layer having a band-gap of more than 2.5 eV, wherein the p-type layer has an ionization energy of at least 5.0 eV; b) an n-doped interlayer comprising a matrix material and at least one n-dopant, wherein the n-doped interlayer has an electron affinity of more than 4.4 eV, preferably the n-dopant of the n-doped interlayer has a HOMO more negative than -4.6 eV, and wherein the ratio of the at least one dopant is 1 to 30 vol.-%; and c) a doped and/or non-doped n-type layer comprising an electron transport material (ETM) and at least one n-dopant, wherein the n-type layer has an electron affinity of less than 4.4 eV.

In a preferred embodiment the first perovskite subcell comprises the following layer sequence: n-type layer(ETL)/first perovskite photoactive layer/p-type layer(HTL), or n-doped n-type layer (n-ETL)/n-type layer(ETL)/first perovskite photoactive layer/p-type layer(HTL)/p-doped p-type layer (p-HTL).

In a preferred embodiment the second perovskite subcell comprises the following layer sequence: n-type layer(ETL)/second perovskite photoactive layer/p-type layer(HTL), or n-doped n-type layer(n-ETL)/n-type layer(ETL)/second perovskite photoactive layer/p-type layer(HTL)/p-doped p-type layer(p-HTL).

In a preferred embodiment the organic subcell comprises the following layer sequence: n-type layer(ETL)/organic photoactive layer/p-type layer(HTL), or n-doped n-type layer(n-ETL)/n-type layer(ETL)/organic photoactive layer/p-type layer(HTL)/p-doped p-type layer(p-HTL).

In a preferred embodiment the at least one acceptor of the second photoactive layer is a fullerene or fullerene derivate, wherein the fullerene or a fullerene is selected from the group consisting of C60, C70, C76, C80, C82, C84, C86, C90 und C94, or a derivative thereof, wherein the derivate preferably is a halogenated fullerene, a hydroxylated fullerene, a carboxylated fullerene, or an aminated fullerene, preferably the fullerene is C60, C70 and/or a derivate thereof, more preferably fullerene C60.

In the context of the present invention a p-type layer is, in particular, a layer comprising a hole transport material (HTM) or a layer comprising a hole transport material (HTM) and a p-dopant. The p-type layer is in particular a hole transport layer (HTL) and favors the transport of positive charge carriers (holes) of a photoactive layer to an electrode and/or between two photoactive layers. Preferably the absolute value of the LUMO of the p-dopant is at least equal to the absolute value of the HOMO of the corresponding p-type layer minus 0.2 eV or larger to allow for efficient p-doping.

In the context of the present invention a n-type layer is, in particular, a layer comprising an electron transport material (ETM) or a layer comprising an electron transport material (ETM) and an n-dopant. The n-type layer is in particular an electron transport layer (ETL). Preferably the absolute value of the HOMO of the n-dopant is at least equal to the absolute value of the LUMO of the corresponding n-type layer plus 0.2 eV or smaller to allow for efficient n-doping.

In a preferred embodiment the p-type layer of the interconnecting unit has an ionization energy of at least 5.2 eV, preferably of at least 5.4 eV, preferably from 5.2 eV to 6.0 eV, or preferably from 5.2 to 5.6 eV.

In a preferred embodiment, the hole transport material (HTM) of the p-type layer is selected from the group consisting of N4,N4,N4',N4'-Tetra[(1,1'-biphenyl)-4-yl]-(1,1'-biphenyl)-4,4'-diamine (BPBPA), N4,N4,N4",N4"-tetra([1,1'-biphenyl]-4-yl)-[1,1':4',1" -terphenyl]-4,4"-diamine (TaTm), N,N'-Bis(naphthalen-1-yl)-N,N'-bis(phenyl)-benzidine (a-NPD), MeO-TAD, Spiro-MeO-TAD, HTM081, TDATA-Derivate, N4,N4'-Bis (9,9-dimethyl-9H-fluoren-2-yl)-N4,N4'-diphenylbiphenyl-4,4'-diamine (BF-DPB), and N3,N3'-Di(biphenyl(-4-yl)-N3,N3'-dimesitylbiphenyl-3,3'-diamin (HT3).

In a preferred embodiment the p-dopant of the p-type layer of the interconnecting unit has a LUMO of less than -4.5 eV, preferably of less than -4.7 eV, preferably of less than -4.9 eV, preferably of less than -5.0 eV, or preferably of less than -5.1 eV.

In a preferred embodiment the p-dopant of the p-type layer of the interconnecting unit is an organic dopant, preferably selected from the group consisting of NDP2, NDP9, C60-F36, and C60-F48. NDP2 and NDP9 are commercial p-dopants of Novaled GmbH.

In a preferred embodiment the p-dopant of the doped p-type layer is an organic p-dopant, preferably the p-dopant has a LUMO more negative than -4.0 eV, preferably more negative than -4.5 eV, preferably more negative than -4.7 eV, or preferably more negative than -5.0 eV.

In a preferred embodiment the p-type layer between subcells (of the interconnecting unit) comprises an organic material as hole transport material (HTM) alone or in combination with an organic p-dopant. Preferably the hole transport material is a tetraaryl-diamine-derivate having at least two amino-residues and in between at least two aryl-units, in particular a compound of general formula II 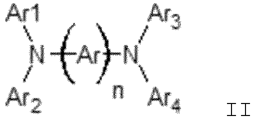 wherein Ar₁, Ar₂, Ar₃ and Ar₄ are independently form each other a non-substituted or substituted aryl-unit, Ar independently from each other a non-substituted or substituted aryl-unit, and n is at least 2, preferably is n = 2,3,4 or 5. Preferably the substituent of Ar1, Ar2, Ar3 and Ar4 is selected from the group consisting of a halogen, amino-group, preferably an amino-group substituted with two aryl-groups, alkyl-group, alkenyl-group, alkoxy-group, and aryl-group.

According to a development of the invention, the matrix material of the n-doped interlayer is a chemical compound of formula I 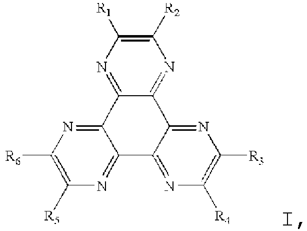 wherein R₁ to R₆ is H or a substituent selected from the group consisting of halogen, -CN, -NO₂, -SO₂R, -SOR, -CF₃,-COOR), -CONHR, -CONRR'), non-substituted or substituted aryl, non-substituted or substituted heteroaryl, and non-substituted or substituted alkyl, wherein R and R' are a non-substituted or substituted alkyl or aryl, or wherein R₁ and R₂, R₃ and R₄, or R₅ and R₆ together form a ring-structure, wherein the ring-structure is an aromatic ring, a heteroaromatic ring, or an aliphatic ring, which ring-structure can be non-substituted or substituted.

In a preferred embodiment the electron transport material (ETM) of the n-doped interlayer is selected from the group consisting of Hexaazatriphenylen, preferably having six electron-withdrawing substituents, preferably Dipyrazino[2,3-f:2',3'-h]quinoxaline-2,3,6,7,10,11-hexacarbonitril (CN-HAT), Tetracyanobenzochinondimethan (TCNQ), Tetracyanonaphthochinondimethan (TCNNQ), Radialene, and derivatives of each.

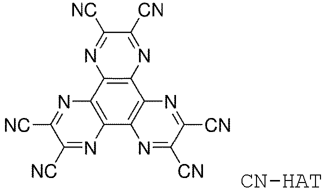

In a preferred embodiment the ratio of the n-dopant in the n-doped interlayer is 1 to 20 vol.-%, preferably 1 to 10 vol.-%, preferably 1 to 5 vol.-%, preferably 2 to 30 vol.-%, preferably 5 to 30 vol.-%, preferably 2 to 20 vol.-%, preferably 2 to 10 vol.-%, preferably 2 to 5 vol.-%, preferably 3 to 30 vol.-%, preferably 3 to 20 vol.-%, preferably 5 to 20 vol.-%, preferably 3 to 10 vol.-%, or preferably 3 to 5 vol.-%.

In a preferred embodiment the n-dopant of the n-doped interlayer is selected from the group consisting of Pentacen or derivatives thereof, TDATA or derivatives thereof, preferably m-MTDATA , TAD or derivatives thereof, preferably Spiro-MeO-TAD, BPBPA or derivatives thereof, TNATA or derivatives thereof, preferably 2-TNATA, TPD or derivatives thereof, preferably MeO-TPD, and Triarylamine-derivatives having at least one alkyl- or alkoxysubstituents at at least two aryl-groups of the amine. Preferably the n-dopant of the n-doped interlayer is an organic material.

In a preferred embodiment the n-type layer of the interconnecting unit has an electron affinity of less than 4.2 eV, preferably of less than 4.0 eV, wherein preferably the electron transport material of the n-type layer is selected from the group consisting of a fullerene or a fullerene derivative, in particular fullerene C60, NTCDA, TNATA, and NTCDI or a derivative thereof.

In a preferred embodiment the n-dopant of the n-type layer of the interconnecting unit has a HOMO more positive than -5.0 eV, preferably more positive than -4.8 eV, or preferably more positive than -4.7 eV.

Preferably the n-dopant of the n-type layer is an organic n-dopant, preferably selected from the group consisting of 2,2'-Diisopropyl-1,1',3,3'-tetramethyl-2,2',3,3',4,4',5,5',6,6',7,7'-dodecahydro-2,2'- bibenzo[d]imidazol (NDR-1); 4,4',5,5'-Tetracyclohexyl-1,1',2,2',3,3'-hexamethyl-2,2',3,3'-tetrahydro-2,2'-biimidazol (NDR-2); 2,2'-diisopropyl-4,4',5,5'-tetrakis(2-methoxyphenyl)-1,1',3,3'-tetramethyl-2,2',3,3'-tetrahydro-1H,1'H-2,2'-biimidazol (NDR-3); 2,2'-diisopropyl-1,1',3,3'-tetramethyl-2,2',3,3'-tetrahydro-1H,1'H-2,2'-bibenzo[d]imidazol (NDR-4); 2,2'-diisopropyl-4,4',5,5'-tetrakis(3-methoxyphenyl)-1,1',3,3'-tetramethyl-2,2',3,3'-tetrahydro-1H,1'H-2,2'-biimidazol (NDR-5); 2-Isopropyl-1,3-dimethyl-2,3,6,7-tetrahydro-5,8-dioxa-1,3-diazacyclopenta[b]naphthene; Bis-[1,3-dimethyl-2-isopropyl-1,2-dihydrobenzimidazolyl-(2)]; 2,2'-Diisopropyl-4,5-bis (2-methoxyphenyl)-4',5'-bis(4-methoxyphenyl)-1,1',3,3'-tetramethyl-2,2',3,3'-tetrahydro-2,2'-biimidazol; and NDN45.

In a preferred embodiment the electron affinity of the n-doped interlayer differs from the electron affinity of the n-type layer by at least 0.5 eV, preferably by at least 0.6 eV, or preferably by at least 0.7 eV.

In a preferred embodiment the ionization energy of the p-type layer differs from the ionization energy of the n-doped interlayer by more than 0.3 eV and less than 1.0 eV, preferably by more than 0.5 eV and less than 0.8 eV.

In a preferred embodiment the p-dopant of the p-type layer of the interconnecting unit is selected from the group consisting of 2,2'-(perfluorocyclohexa-2,5-diene-1,4-diylidene)dimalononitril (TCNQ-1), N'-Dicyan-2,3,5,6-tetrafluoro-1,4-chinondiimin; N,N'-Dicyan-2,5-dichloro-1,4-chinondiimin, N,N'-Dicyan-2,5-dichloro-3,6-difluoro-1,4-chinondiimin, N,N'-Dicyan-2,3,5,6,7,8-hexafluoro-1,4-naphthochinondiimin, 1,4,5,8-Tetrahydro-1,4,5,8-tetrathia-2,3,6,7-tetracyano-anthrachinon, 1,3,4,5,7,8-Hexafluoronaphtho-2,6-chinontetracyanomethan (TCNQ-7), 2,2'-(2,5-Dibrom-3,6-difluorcyclobexa-2,5-dien-1,4-diyliden)dimalononitril, 4,4'-(1E,1'E)-(2-cyano-3,6-difluoro-5-isocyanocyclohexa-2,5-diene-1,4-diylidene)bis-(cyanomethan-1-yl-1-ylidene)bis(2,3,5,6-tetrafluorobenzonitril), 2,2',2"- (Cyclopropan-1,2,3 - triyliden)tris(2-(2,6-dichlor-3,5-difluor-4-(trifluormethyl)phenyl)acetonitril), (2E,2'E,2"E)-2,2',2"-(cyclopropane-1,2,3-triylidene)tris(2-(perfluorophenyl)acetonitril), 2,2',2"-(cyclopropane-1,2,3-triylidene)tris(2-(perfluorobiphenyl-4-yl)acetonitril), 2,2',2"-(cyclopropane-1,2,3-triylidene)tris(2-(2,6-dichloro-3,5-difluoro-4-(trifluoromethyl)phenyl)-acetonitril), and Benzene-acetonitril, α,α',α"-1,2,3-cyclopropanetriylidenetris[4-cyano-2,3,5,6-tetrafluoro-(PR-1) .

In the context of the present invention, a BODIPY compound refers to a compound derived from a core structure of general formula C₉H₇BN₂F₂, in particular a compound having a Bor-Difluorid-group having a Dipyrromethen-group, more particular a compound 4,4-Difluoro-4-bora-3a,4a-diaza-s-Indacene.

In a preferred embodiment the BODIPY compound is a compound of the general formula B1 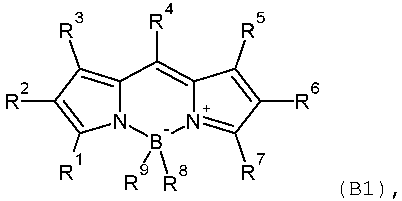
wherein R1 and R2 and/or R6 and R7, in each case together, form a heterocyclic 5-membered ring or 6-membered ring having at least one heteroatom selected from S, O, N and P, or a homocyclic 6-membered ring having no further fusion, and R1 and R2 or R6 and R7 are independently an H or another radical if they do not form a heterocyclic or homocyclic ring,
R3, R4 and R5 are independently H or a radical selected from aryl, alkyl, fluorinated or partly fluorinated alkyl, unsaturated alkyl, and R8 and R9 are F. In a preferred embodiment in the compound B1 R1 and R2 and/or R6 and R7, in each case together, form a heterocyclic 5-membered ring or 6-membered ring having at least one heteroatom selected from S, O, N and P.

In a preferred embodiment the BODIPY compound is a compound of general formula B2 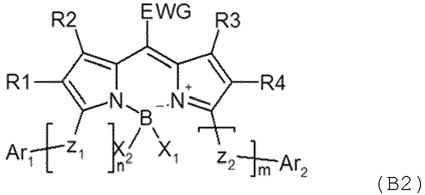
wherein n, m are each independently 0, 1 or 2;
wherein X1, X2 are each independently selected from halogen, CN, alkyl, fluorinated or partially fluorinated alkyl, alkenyl, alkynyl, alkoxy, aryl or heteroaryl;
wherein EWG is selected from CN, or CF3, or a fully or partially fluorinated, branched or unbranched, linear or cyclic alkyl chain in which H-atoms and/or C-atoms may be substituted;
wherein z1 and z2 selected from the groups (II) to (IV): 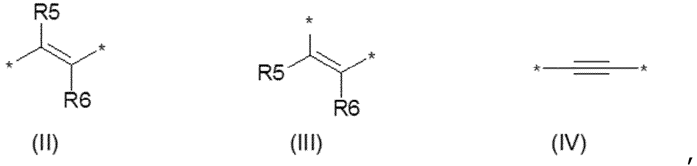
wherein "*" denotes in each case the bonding side the substituent z1 or z2 to the dipyrrin skeleton and to the aryl substituents Ar1, Ar2
wherein R1 to R4 are each independently selected from H, CN, halogen, substituted or unsubstituted, branched or unbranched, linear or cyclic alkyl chain;
wherein R5 and R6 are each independently selected from H, halogen, CN, substituted or unsubstituted, branched or unbranched, linear or cyclic alkyl chain;
in which Ar1 and Ar2 are each independently selected from aryl or heteroaryl, wherein Ar1 in the case of n = 0 and/or Ar 2 in the case of m = 0 corresponds to the formula (V), and "*" is the bonding side of the substituent Ar1, Ar2 refers to the dipyrrin skeleton, 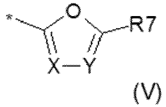
wherein X is selected from N or C-R8 and Y is selected from N or C-R9; wherein R7 to R9 are independently selected from a group consisting of H, halogen, branched or linear, cyclic or open-chain alkyl or aryl, wherein H-atoms and/or C-atoms of the alkyl or aryl may be substituted, or from a group of consisting alkenyl, O-alkyl, S-alkyl, O-alkenyl, S-alkenyl, alkynyl, aryl or heteroaryl, wherein in all these groups H-atoms may be substituted, or from CN or NR'R ", with R 'and R" each independently selected from: H, branched or linear, cyclic or open-chain alkyl, wherein H and / or C-atoms of the alkyl may be substituted; or wherein R7 and R9 may together form a homo- or heterocyclic, saturated or unsaturated, substituted or unsubstituted ring; and Ar1 is in the case of n> 0 and/or Ar 2 is in the case of m> 0, a substituted or unsubstituted heterocyclic 5-membered ring, with preferably heteroatoms selected from S or O.

In a preferred embodiment the BODIPY compound is a compound of general formula B3 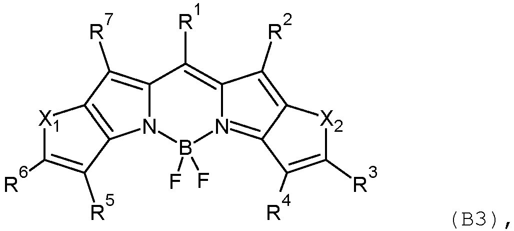
wherein X1 and X2 independently of one another are O, S or N-R8, with R8 selected from the group consisting of H, alkyl, aryl, and heteroaryl,
R1 is a substituted homocyclic 6-membered ring, wherein at least one H-atom is substituted by an electron-withdrawing substituent selected from the group consisting of F, Cl, CN, CF3, and COR8, with R8 being C1-C4 alkyl, or is a substituted or unsubstituted heterocyclic 5-membered ring or 6-membered ring, wherein the heterocyclic 5-membered ring or 6-membered ring has at least one sp2-hybridized N-atom with a free electron pair and/or has at least one heteroatom selected from O, S, or N, wherein in the substituted heterocyclic 5-membered ring or 6-membered ring at least one H-atom is substituted by an electron-withdrawing substituent selected from the group consisting of F, Cl, CN, CF₃, and COR9, with R9 being C1-C4 alkyl,
R2 and R7 independently of one another are selected from the group consisting of H, halogen, CN, alkyl, fluorinated or partially fluorinated alkyl, unsaturated alkyl, and aryl,
R4 and R5 independently of one another are selected from the group consisting of H, halogen, CN, alkyl, fluorinated or partially fluorinated alkyl, unsaturated alkyl, and alkoxy, and R3 and R6 independently of one another are a substituted or unsubstituted homocyclic 6-membered ring or a substituted or unsubstituted heterocyclic 5-membered ring or 6-membered ring.

In a preferred embodiment in the compound of general formula B3, X1 and X2 are S or X1 and X2 are O, and/or at least one H-atom in the homocyclic 6-membered ring and/or in the heterocyclic 5-membered ring or 6-membered ring R1 is substituted by F or CF₃, preferably by F.

In a preferred embodiment in the compound of general formula B3, R3 and R4 and/or R5 and R6 in each case together form a heterocyclic 5-membered ring or 6-membered ring having at least one heteroatom selected from O, S or N, preferably O or S, wherein preferably the heterocyclic 5-membered ring or 6-membered ring is non-substituted, or form a homocyclic 6-membered ring.

In a preferred embodiment the BODIPY compound is a compound of general formula B4 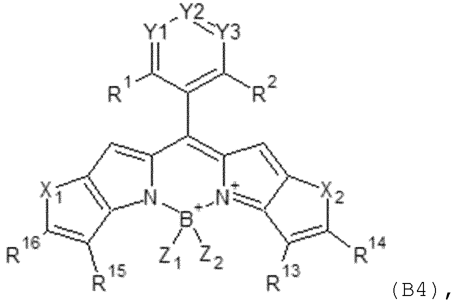
with Y₁ selected from the group consisting of N and CR21, wherein R21 is selected from the group consisting of H, alkyl, O-alkyl, S-alkyl, halogen, preferably F or Cl, CN and CF₃;
with Y₂ selected from the group consisting of N and CR22, wherein R22 is selected from the group consisting of H, alkyl, O-alkyl, S-alkyl, halogen, preferably F or Cl, CN, and CF₃;
with Y₃ selected from the group consisting of N and CR23, wherein R23 is selected from the group consisting of H, alkyl, O-alkyl, S-alkyl, Halogen, preferably F or Cl, CN, and CF₃;
with Z₁ and Z₂ F or CF₃;
with X₁ and X₂ independently from each other O, S or N-R8, wherein R8 is selected from the group consisting of H, alkyl and aryl, wherein preferably X₁ and X₂ are S, or X₁ and X₂ are O;
with R1 and R2 independently from each other selected from the group consisting of H, F, Cl, Br, CN, CF₃, CHF₂, CH₂F, C1-C4-alkyl, O-C1-C4-alkyl, S-C1-C4-alkyl, and N-(C1-C4-alkyl)₂, with the proviso that at least R1 or R2 is Br, Cl, CF₃, CHF₂, CH₂F or CH₃;
wherein R13 and R15 are independently from each other selected from the group consisting of H, halogen, CN, alkyl, O-alkyl, and S-alkyl, preferably H or C1-C4-alkyl;
wherein R14 and R16 are independently selected from the group consisting of a non-substituted or with halogen, alkyl, at least partially fluorinated alkyl, O-alkyl and/or at least partially fluorinated O-alkyl substituted heterocyclic 5-membered ring or 6-membered ring, preferably with a heteroatom independently selected from S, O and N, und a non-substituted and with halogen, alkyl, at least partially fluorinated alkyl, O-alkyl and/or at least partially fluorinated O-alkyl substituted homocyclic 6-membered ring, preferably a non-substituted or substituted heterocyclic 5-membered ring, and a non-substituted or substituted homocyclic 6-membered ring.

In a preferred embodiment the BODIPY compound is a compound of general formula B5 and B6 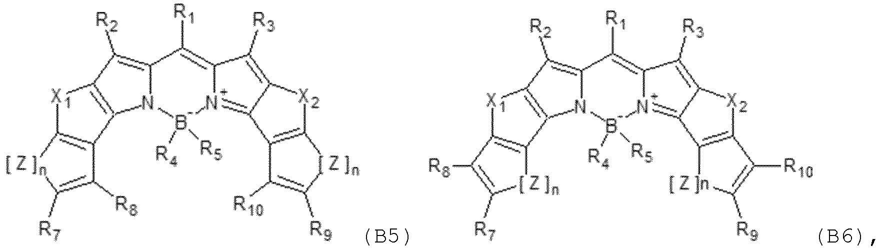
with X₁ and X₂ independently from each other O, S, or NR₆,
with R₆ selected from the group consisting of H, alkyl, alkoxy, amino, aryl, and heteroaryl,
with R₁ selected from the group consisting of F, at least partially fluorinated alkyl, and an aromatic heterocyclic 5-membered ring or 6-membered ring or aa aromatic homocyclic 6-membered ring,
with R₂ and R₃ independently from each other selected from the group consisting of H, halogen, CN, alkyl, alkoxy, amino, aryl and heteroaryl,
with R₄ and R₅ independently from each other selected from the group consisting of halogen, preferably F, and fluorinated or partially fluorinated alkyl,
with Z independently from each other selected from the group consisting of O, S, CH₂, CHR₁₁, CR₁₂R₁₃, SiHR₁₁, SiR₁₂R₁₃, NH, NR₁₄, PR₁₅, with R₁₁, R₁₂, R₁₃, R₁₄ and R₁₅ independently selected form the group consisting of halogen, alkyl, alkoxy, amino, aryl, and heteroaryl, with n independently 1 or 2,
wherein R₇ and R₈ and/or R₉ and R₁₀ together form a heterocyclic 5-membered ring or a 6-membered ring comprising at least one heteroatom selected from the group consisting of O, S, N, Si and P, or a homocyclic 6-membered ring, wherein the heterocyclic 5-membered ring or 6-membered ring or the homocyclic 6-membered ring each can be fused.

In the context of the present invention, an ADA compound or an ADA-oligomer refers to a conjugated acceptor-donor-acceptor-oligomer (ADA') having a first acceptor-unit (A) and a second acceptor-unit (A'), each bound to the donor-unit (D).

In a preferred embodiment the A-D-A compound is:
a conjugated Acceptor-Donor-Acceptor-Oligomer (A-D-A'-Oligomer) with a acceptor unit (A) and a further acceptor unit (A'), each bound to a donor unit (D), wherein the donor unit (D) is an extended donor unit, wherein the donor unit (D) comprises at least two monomers and/or at least 8 atoms having a common conjugated π-electron-system, which are formed from at least one atom selected from the group consisting of C, N, B, P, S, Si and O; or a conjugated Acceptor-Donor-Acceptor-Oligomer (A-D-A'-Oligomer) with a acceptor unit (A) and a further acceptor unit (A'), each bound to a donor unit (D), wherein the acceptor unit (A) and a further acceptor unit (A') each are an extended acceptor unit, wherein the acceptor unit (A) and the further acceptor unit (A') each comprises at least two monomers and/or at least 8 atoms having a common conjugated π-electron-system, which are formed from at least one atom selected from the group consisting of C, N, B, P, S, Si and O; or
a conjugated Acceptor-Donor-Acceptor-Oligomer (A-D-A'-Oligomer) with a acceptor unit (A) and a further acceptor unit (A'), each bound to a donor unit (D), wherein either at least the donor unit (D) is an extended donor unit or at least the acceptor unit (A) and a further acceptor unit (A') each are an extended acceptor unit, wherein in case of an extended structure the donor unit (D), the acceptor unit (A) and the further acceptor unit (A') comprises at least two monomers and/or at least 8 atoms having a common conjugated π-electron-system, which are formed from at least one atom selected from the group consisting of C, N, B, P, S, Si and O.

In a preferred embodiment the A-D-A compound is a compound of general formula A1: 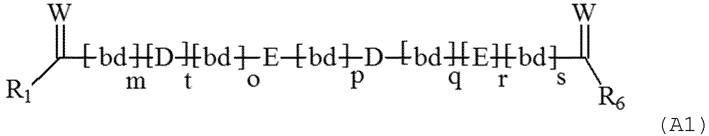
wherein each W is independently selected from C(CN)₂, CHCN, C(CN)COOR' wherein R' is in each case selected from C1-C10 alkyl, C3-C10 aryl and C2-C8 heteroaryl, more preferably selected from C(CN)₂, CHCN,
R₁ and R₆ are each independently selected from H, C1-C30 alkyl, C1-C30 perfluoroalkyl, C3-C10 aryl, C2-C8-heteroaryl, CN,
wherein the D groups are selected from: 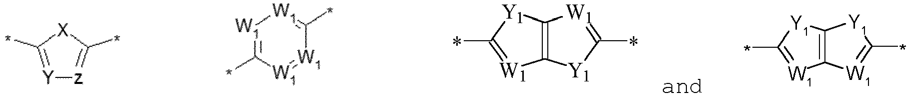
wherein Y₁ is selected from: O, S, Se, P(R), P(O)R, Si(RR'), C(RR') and N(R) and
W₁ is independently selected from: N and C-R wherein R and R' are each independently selected from substituted and unsubstituted C1 to C30 alkyl, C3-C6 aryl and C3-C8 heteroaryl and
wherein each X is selected independently from O, NR', S, Se, wherein R' is selected from C1-C30 alkyl, C1-C10 aryl and C1-C8 heteroaryl,
each Y is independently selected from N and CR9 wherein R9 = H, halogen, C1-C30 alkyl, C1-C30 alkenyl, C1-C30 alkynyl, each linear or branched, substituted or unsubstituted, OR', SR', SiR'₃, NR'₂, wherein R' is selected from C1-C10 alkyl, C3-C10 aryl and C1-C8 heteroaryl,
each Z is independently selected from N and CR10 wherein R10 = H, halogen, C1-C30 alkyl, C1-C30 alkenyl, C1-C30 alkynyl, each linear or branched, substituted or unsubstituted, OR', SR', SiR'₃, NR'₂, wherein R' is selected from C1-C10 alkyl, C3-C10 aryl and C1-C8 heteroaryl,
wherein R9 and R10 may form a ring, preferably a 5-membered or 6-membered ring,
wherein the E groups are selected from: 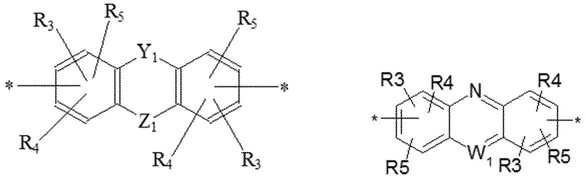 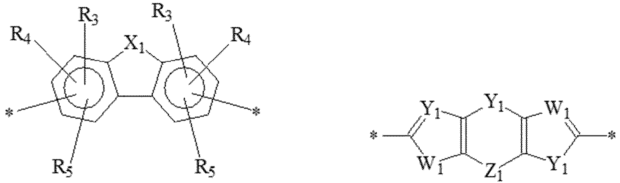 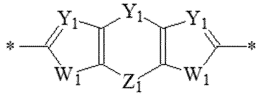 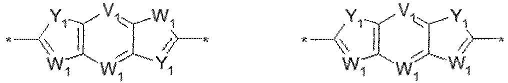 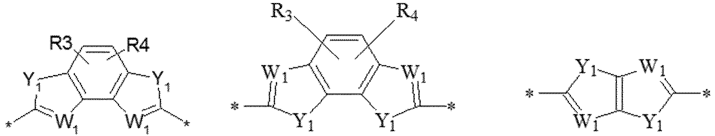 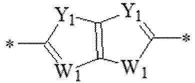 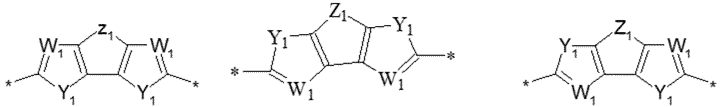 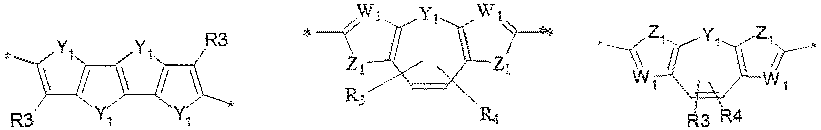
wherein V₁ and W₁ are each independently selected from: N and C-R
wherein R = H, halogen, C1-C30 alkyl, C1-C30 alkenyl, C1-C30 alkynyl, each linear or branched, substituted or unsubstituted, C3-C10 aryl or C1-C8 heteroaryl, substituted or unsubstituted, OR', SR', SiR'₃, NR'₂, wherein R' is selected from C1-C10 alkyl, C1-C10 aryl and C1-C8 heteroaryl,
Y₁ and Z₁ are each selected from: O, S, Se, P (R), P(O)R, Si(RR'), C(RR') and N(R), wherein R and R' are each independently selected from H, linear or branched, substituted or unsubstituted C1-C30 alkyl, substituted or unsubstituted aryl, substituted or unsubstituted heteroaryl, acyl (COR'), COOR' and OR', wherein R' is selected from C1-C30 alkyl, C3-C10 aryl and C1-C8 heteroaryl, and
X₁ is selected from: O, S, Se, and R and R' are each independently selected from H, C1 to C20 alkyl, linear or branched, substituted or unsubstituted, C3 to C6 aryl or C3 to C8 heteroaryl, OR', SR', SiR'₃, NR'₂, wherein R' is selected from C1-C10 alkyl, C3-C6 aryl and C3-C8 heteroaryl,
and wherein R3, R4 and R5 are each independently H, C1 to C20 alkyl, linear or branched, non-substituted or substituted, C3 to C6 aryl or C3 to C8 heteroaryl, OR', SR', SiR'₃, NR'₂, wherein R' may be selected from C1-C10 alkyl, C3-C6 aryl and C3-C8 heteroaryl,
bd is independently *-C≡C-* or *-C ≡ C-*,
n, m, o, p, q, and r, s and t may each independently be 0 or 1, with the proviso that at least one parameter is 1,
wherein one donor unit formed from the groups bd, E and D has at least 10 conjugated electrons and the bonds identified with the asterisk* indicate the bonds to further groups in the compounds.

In a preferred embodiment die A-D-A compound is a compound of general formula A2: 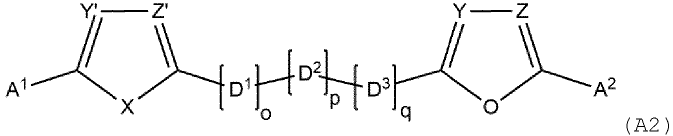
with Y, Y', Z and Z' each independently selected from: N or CR^{a}, with X selected from: O, S, Se, Si(R^{b}R^{c}), P(R^{b}), P(O)R^{b},
wherein the R^{a} to R^{c} radicals are each independently selected from the group of the following radicals: H, halogen, CN, NR^{d}R^{e} wherein R^{d} and R^{e} are each independently selected from the group of the radicals: H, and cyclic or open-chain C₁-C₂₀-alkyl, wherein individual carbon atoms may be replaced by heteroatoms and wherein hydrogen atoms in the alkyl radical may be substituted, cyclic or open-chain C₁-C₂₀ alkyl, wherein individual C-atoms may be replaced by heteroatoms, cyclic or open-chain C₁-C₂₀ O-alkyl, cyclic or open-chain C₁-C₂₀ S-alkyl, cyclic or open-chain C₂-C₂₀ alkenyl, cyclic or open-chain C₂-C₂₀ O-alkenyl, cyclic or open-chain C₂-C₂₀ S-alkenyl, cyclic or open-chain C₂-C₂₀ alkynyl, aryl, heteroaryl, wherein hydrogen atoms in the alkyl, O-alkyl, S-alkyl, alkenyl, O-alkenyl, S-alkenyl, alkynyl, aryl and heteroaryl radicals may each independently be substituted; and wherein A¹ is selected from the group of the following radicals: 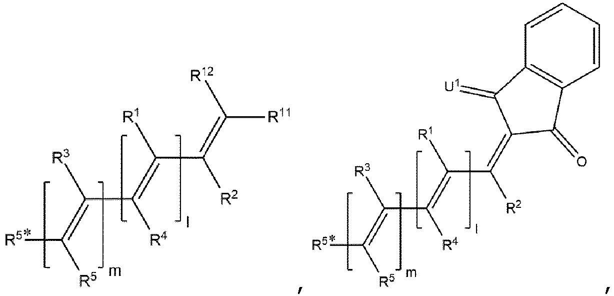 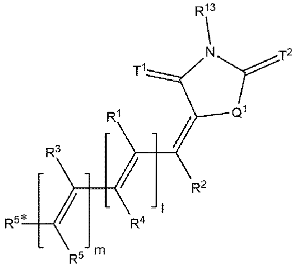
and wherein A² is selected from the group of the following radicals: 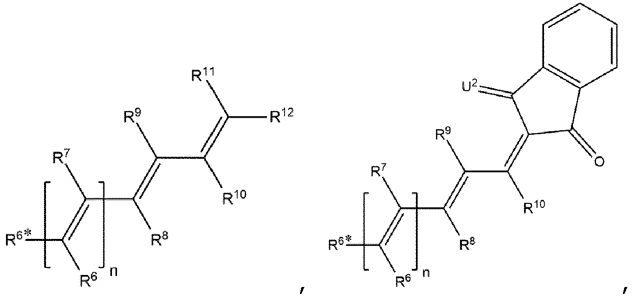 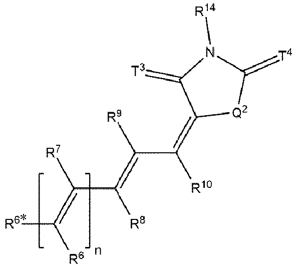
wherein m, 1 and n are each independently 0 or 1,
wherein R1 to R10 and R5* and R6* for the A1 and A2 groups are each independently selected from the group of the following radicals: H, halogen, CN, cyclic or open-chain C1-C20 alkyl, cyclic or open-chain C2-C20 alkenyl, cyclic or open-chain C1-C20 O-alkyl, aryl, heteroaryl, wherein hydrogen atoms in the alkyl, alkenyl, O-alkyl, aryl and heteroaryl radicals may each independently be substituted; and wherein it is possible in each case independently for a ring to be formed by the following pairs of radicals together: R1 and R3, R2 and R4, R4 and R5, R3 and R5*, R7 and R9, R6 and R8, R8 and R10, R6* and R7; with the proviso that, for A1, exactly one of the R5*, R5, R4, R3, R2 and R1 radicals represents a linkage 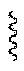 by means of which A1 is bonded to the structural element 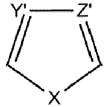
in the compound of the general formula (A2), and with the proviso that, for A², exactly one of the R⁶*, R⁶, R⁷, R⁸, R⁹ and R¹⁰ radicals represents a linkage 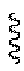 by means of which A² is bonded to the structural element 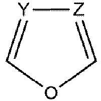 of the compound of the general formula (A2);
wherein R¹¹ and R¹² for the A¹ and A² groups are each independently selected from the group of the radicals: H, CN, COOR^{f} wherein R^{f} is selected from the group of the radicals: H and cyclic or open-chain C₁-C₂₀-alkyl, wherein hydrogen atoms in the alkyl may be fluorinated, with the proviso that R¹¹ and R¹² cannot both be H, wherein the R¹³ and R¹⁴ radicals are independently selected from the same group of radicals as R^{d} and R^{e}; and wherein U¹, U², and T¹ to T⁴ are each independently selected from the group consisting of: O, S and C(CN)₂; and wherein Q¹ and Q² are each independently selected from the group consisting of: O and S;
and wherein the conjugated D¹, D² and D³ blocks are each independently selected from the group of the following structural units: 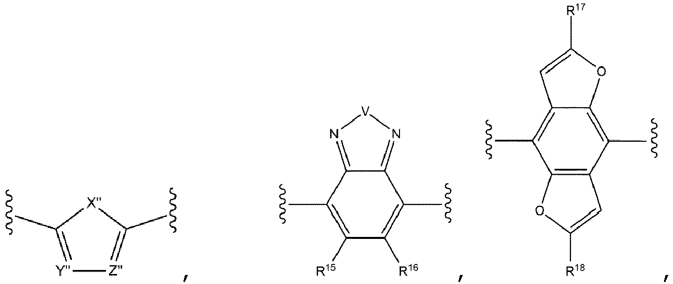 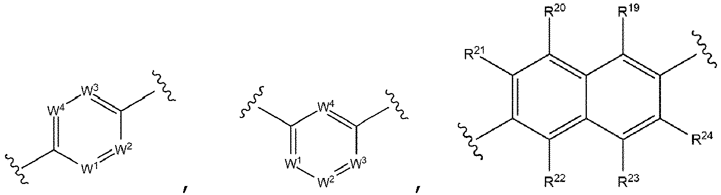 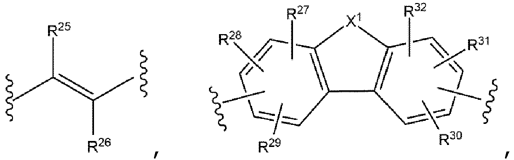
wherein the coefficients o and q each independently assume the values of 0 and 1 and the coefficient p assumes the values of 0, 1, 2, 3, 4 and 5, with the proviso that at least one of the coefficients o, p and q is not 0,
with Y'' selected from: N or CR^{g};
with Z'' selected from: N or CR^{h};
with X'' selected from: O, S, Se, Si(RⁱR^{j}), P(Rⁱ), P(O)Rⁱ;
with V selected from: O, S or NR^{k};
with X¹ selected from: NR^{l}, CR^{l}R^{m};
with W¹ to W⁴ independently selected from: N, CRⁿ;
wherein the R^{g} to Rⁿ radicals and the R¹⁵ to R³² radicals are each independently selected from the group of the radicals as R^{a} to R^{c}; and wherein the R^{g} and R^{h} radicals may be joined to one another in the form of a ring structure and wherein an aryl radical may be fused onto the ring structure, wherein any aryl radical fused to the ring structure may be substituted.

In a preferred embodiment die A-D-A compound is a compound of general formula A3:

EWG1 -(T1)ₐ-(T2)_{b}-(Z)_{c}-(T3)_{d}-(T4)ₑ-EWG2 (A3)

with the parameters a, b, d and e being each independently of one another 0 or 1,
with the parameter c being 1, 2, 3, 4 or 5,
wherein the general group Z is a block of two groups M and N, linked as *-M-N-* or *-N-M-*, wherein * designates the attachment to the groups T1 to T4 or EWG1 and EWG2,
wherein the groups M each independently of one another are selected from: 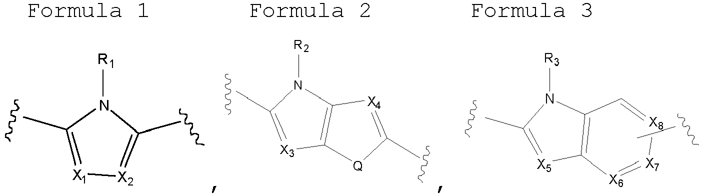
wherein the groups N each independently of one another are selected from: 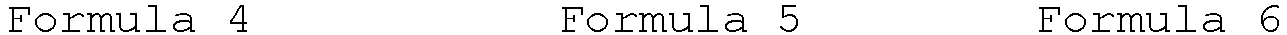 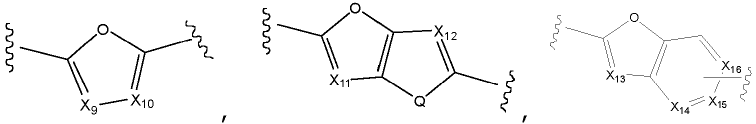
wherein M and N are each linked such that at least one N-atom of the group M and one O-atom of the group N are each joined to one another via 2 C-atoms, and 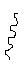 designates the attachment to the other groups in the compound of the general formula (A3), with X₁-X₁₆ independently of one another being selected from N or C-R, with the proviso that in the groups of the formulae 3 and 6, in each case one group from the groups X₈/X₇ and X₁₆/X₁₅ designates the attachment 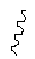 to the other groups in the compound of the general formula (A3),
with each R independently of any other being selected from a group composed of H, halogen, branched or linear, cyclic or open-chain C₁-C₂₀ alkyl, wherein hydrogen atoms of the C₁-C₂₀ alkyl may be substituted and C-atoms of the C₁-C₂₀ alkyl may be replaced by heteroatoms; C₂-C₂₀ alkenyl, O-alkyl, S-alkyl, O-alkenyl, S-alkenyl, alkynyl, aryl, heteroaryl, it being possible for hydrogen atoms to be substituted in all of these groups; CN, NR'R'', with R' and R'' each independently of one another being selected from: H, branched or linear, cyclic or open-chain C₁-C₂₀ alkyl, wherein hydrogen atoms of the C₁-C₂₀ alkyl may be substituted and C-atoms of the C₁-C₂₀ alkyl may be replaced by heteroatoms,
wherein R₁ to R₃ each independently of one another are selected from a group composed of H, branched or linear, cyclic or open-chain C₁-C₂₀ alkyl, wherein hydrogen atoms of the C₁-C₂₀ alkyl may be substituted and C-atoms of the C₁-C₂₀ alkyl may be replaced by heteroatoms; substituted or unsubstituted C₂-C₂₀ alkenyl, substituted or unsubstituted aryl, substituted or unsubstituted heteroaryl, CN,
with each Q independently of any other being selected from S, O, Se, NR‴, wherein R‴ is defined as for R₁ to R₃,
wherein the electron-withdrawing groups EWG1 and EWG2 independently of one another are electron-withdrawing groups having at least one C=C double bond,
wherein the groups T1, T2, T3 and T4 each independently of one another are selected from: 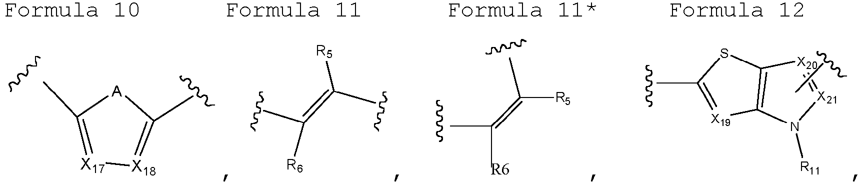 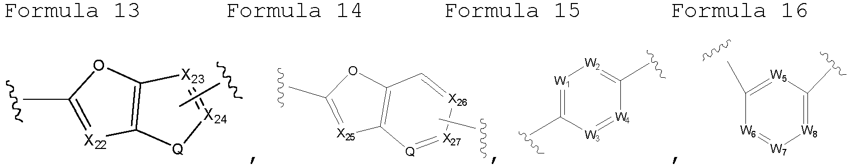
and 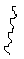 designates the attachment to the other groups in the compound of the general formula (A3),
with R5 and R6 each independently of one another being selected from a group: H, CN, F, aryl, heteroaryl, C₂-C₂₀ alkenyl, alkynyl, branched or linear, cyclic or open-chain C₁-C₂₀ alkyl, wherein hydrogen atoms of the C₁-C₂₀ alkyl may be substituted, where, if the substituent R₁₃ is present in the compound of the formula (A3), a ring closure between R₅ with R₁₃ or R₆ with R₁₃ is possible, with the proviso that between R₅ and R₁₃ or between R₆ and R₁₃ in each case the double bond from formula 11 is located, is possible, with W₁ to W₈ each independently of one another being selected from N, CR, wherein R is defined as described above, with X₁₇ to X₂₇ independently of one another being selected from C-R, wherein R is defined as described above, and with the proviso that in the groups of the formulae 12, 13 and 14, in each case one group from the groups X₂₀/X₂₁, X₂₃/X₂₄ and X₂₆/X₂₇ designates the attachment 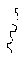 to the other groups in the compound of the general formula (A3),
with A being S, O, NRʺʺ, Se
with Q being S, O, NR"", Se
wherein for the groups A and Q, the substituent R'''' in each case independently of any other is selected from H, CN, branched or linear, cyclic or open-chain C₁-C₂₀ alkyl, wherein the H-atoms of the C₁-C₂₀ alkyl may be substituted; C₂-C₂₀ alkenyl, O-alkyl, S-alkyl, O-alkenyl, S-alkenyl, alkynyl, substituted or unsubstituted aryl, substituted or unsubstituted heteroaryl.

In a preferred embodiment die A-D-A compound is a compound of general formula A4

A1-(T1)ₐ-(T2)_{b}-(Z)_{c}-(T3)_{d}-(T4)ₑ-A2 (A4)

with the parameters a, b, d, e each independently 0 or 1, with the proviso that at least one of the parameters a, b, d, e = 1,
with the parameter c = 1, 2, or 3,
wherein the general group Z is a block of two groups M and N, linked as *-M-N-*or *-N-M-*, wherein * denotes the attachment to the groups T1, T2, T3, T4, A1, and A2,
wherein the groups M are each independently selected from: 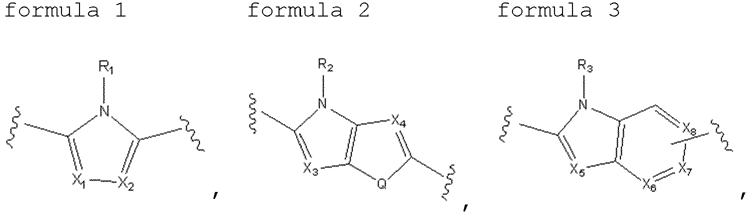 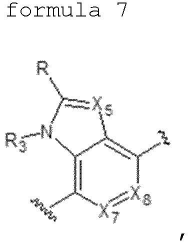
wherein the groups N are each independently selected from: 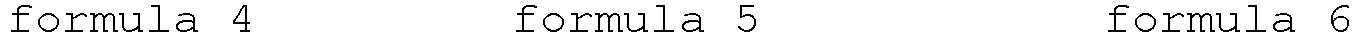 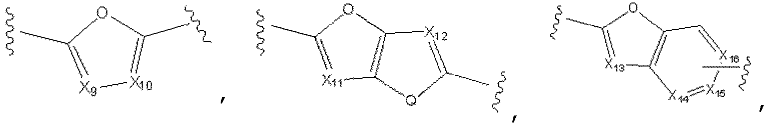 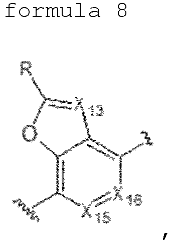
wherein M and N are each linked such that at least one N-atom of the group M and an O-atom of the group N are each bonded to one another via 2 C-atoms, and 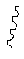 denotes the attachment to the other groups in the compound of the general formula (A4), with X₁-X₁₆ independently selected from N or C-R, with the proviso that, in each of the groups of the formulas 3 and 6, a group from the groups X₈/X₇ and X₁₆/X₁₅ denotes the attachment 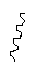 to the other groups in the compound of the general formula (A4),
with R in each case independently selected from the group consisting of H, halogen, branched or linear, cyclic or open-chain C₁-C₁₀ alkyl, wherein H-atoms of the C₁-C₁₀ alkyl can be substituted, and C-atoms of the C₁-C₁₀ alkyl can be substituted by heteroatoms, C₂-C₁₀ alkenyl, O-alkyl, S-alkyl, O-alkenyl, S-alkenyl, alkynyl, aryl, heteroaryl, wherein, in all of these groups, H-atoms can be substituted, CN, NR₁₀R₁₁, with R₁₀ and R₁₁ each independently selected from H, branched or linear, cyclic or open-chain C₁-C₁₀ alkyl, wherein H-atoms of the C₁-C₁₀ alkyl can be substituted, and C-atoms of the C₁-C₁₀ alkyl can be substituted by heteroatoms,
with R₁ to R₃ each independently selected from the group consisting of H, branched or linear, cyclic or open-chain C₁-C₁₀ alkyl, wherein H-atoms of the C₁-C₁₀ alkyl can be substituted, and C-atoms of the C₁-C₁₀ alkyl can be substituted by heteroatoms, substituted or unsubstituted C₂-C₁₀ alkenyl, substituted or unsubstituted aryl, substituted or unsubstituted heteroaryl, CN,
wherein the electron-withdrawing groups A1 and A2 are, independently, electron-withdrawing groups having at least one C=C double bond,
wherein the groups T1, T2, T3, and T4 are each independently selected from: 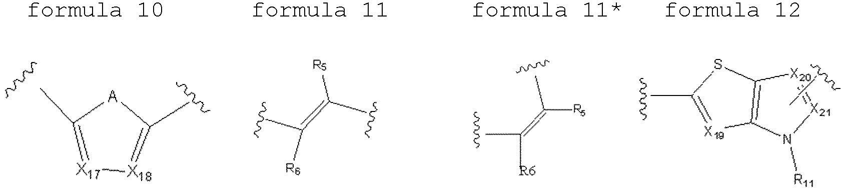 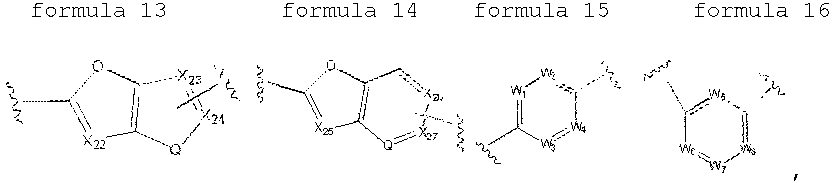
wherein 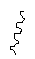 denotes the attachment to the other groups in the compound of the general formula (A4), with the proviso that at least one of the groups T1 to T4 is the formula 10, with R₅ and R₆ each independently selected from the group consisting of H, CN, F, aryl, heteroaryl, C₂-C₁₀ alkenyl, alkynyl, branched or linear, cyclic or open-chain C₁-C₁₀ alkyl, wherein H-atoms of the C₁-C₁₀ alkyl can be substituted, wherein, if the substituent R₁₃ is present in the compound of the formula (A4), a ring closure between R₅ with R₁₃ or R₆ with R₁₃ is possible, with the proviso that, between R₅ and R₁₃ or between R₆ and R₁₃, in each case there is located the double bond from formula 11, with W₁ to W₈ each independently selected from N, CR, wherein R is defined as described above,
with X₁₇ and X₁₈ independently selected from N and C-R, wherein R is defined as described above, with the proviso that X₁₇ or X₁₈ is N, with X₁₉ to X₂₇ independently selected from N and C-R, wherein R is defined as described above, and with the proviso that, in each of the groups of the formulas 12, 13, and 14, a group from the groups X₂₀/X₂₁, X₂₃/X₂₄, and X₂₆/X₂₇ denotes the attachment 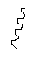 to the other groups in the compound of the general formula (A4),
with A selected from the group consisting of S, O, NR₉, and Se, with Q selected from the group consisting of S, O, NR₉, and Se, wherein, for the groups A and Q, the substituent R₉ is in each case independently selected from H, CN, branched or linear, cyclic or open-chain C₁-C₁₀ alkyl, wherein the H-atoms of the C₁-C₁₀ alkyl may be substituted, C₂-C₁₀ alkenyl, O-alkyl, S-alkyl, O-alkenyl, S-alkenyl, alkynyl, substituted or unsubstituted aryl, substituted or unsubstituted heteroaryl.

In a preferred embodiment the first perovskite photoactive layer, the second perovskite photoactive layer, and the organic photoactive layer are vacuum deposited. In a preferred embodiment the photoactive layers and the transport layers are vacuum deposited. In a preferred embodiment all the layers of the stack are vacuum deposited.

In a preferred embodiment the photovoltaic element is a solar cell. In a preferred embodiment the photovoltaic element is a flexible photovoltaic element. A flexible photovoltaic element is understood to mean, in particular, a photovoltaic element which is bendable and/or extensible in a specific region. In a preferred embodiment the substrate is flexible and/or the stack of the photovoltaic element is flexible.

All-inorganic perovskite single junction solar cell from vacuum deposition generally show lower efficiency compared to organic perovskite solar cells processed from solution. For the all-inorganic perovskite single junction CsPbI₂Br from vacuum deposition a power conversion efficiency (PCE) of 10% is reported (Chem. Mater., 2020, 32, 19, 8641-8652). For the all-inorganic perovskite single junction CsPbI₂Br from vacuum deposition a power conversion efficiency (PCE) of 12.75% is reported (Adv.Funct.Mater., 2023, 33, 2214414).

### Description of the Drawings

The invention is described in more detail with reference to working examples and figures. The working examples are intended to describe the invention without restricting it. It is demonstrated that two perovskite subcells and an organic subcell can improve the efficiency compared to a perovskite/perovskite tandem cell or a perovskite/organic tandem cell, in particular processed by vacuum deposition. Furthermore, the durability of such photovoltaic cells is improved.

In all figures, identical and functionally identical elements are provided with the same reference signs, so that in this respect reference is made to the preceding description. The layer thicknesses and the ratio of the layer thicknesses to each other do not correspond to the actual dimensions. donor1, donor2, and donor3 are NIR absorber materials.
Fig. 1 shows a schematic illustration of an exemplary embodiment of a multi-junction photovoltaic element comprising a first perovskite subcell, a second perovskite subcell and an organic subcell in cross-section;
Fig. 2 shows a schematic illustration of an exemplary embodiment of a multi-junction photovoltaic element comprising a first perovskite subcell, a second perovskite subcell and an organic subcell having a n-doped interlayer between the second perovskite subcell and the organic subcell in cross-section;
Fig. 3 shows a schematic illustration of an exemplary embodiment of a multi-junction photovoltaic element comprising a first perovskite subcell, a second perovskite subcell and an organic subcell having a n-doped interlayer between the perovskite subcells in cross-section;
Fig. 4 shows a schematic illustration of an exemplary embodiment of a multi-junction photovoltaic element comprising a first perovskite subcell, a second perovskite subcell and an organic subcell having n-doped interlayers between the subcells in cross-section; and
Fig. 5 shows a schematic illustration of an exemplary embodiment of a multi-junction photovoltaic element comprising a first perovskite subcell, a second perovskite subcell and an organic subcell having n-doped interlayers between the subcells and a passivation layer at each perovskite subcell in cross-section.

### Working examples

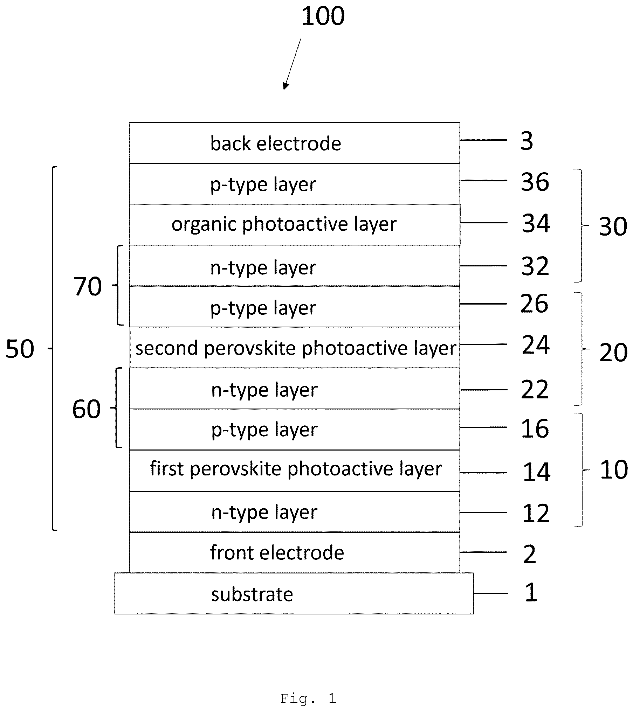

Fig. 1 shows a schematic illustration of an exemplary embodiment of a multi-junction photovoltaic element 100 comprising a first perovskite subcell 10, a second perovskite subcell 20 and an organic subcell 30 in cross-section.

The multi-junction photovoltaic element 100 with at least three subcells 10,20,30 comprises a front electrode 2, a back electrode 3, and a stack 50 arranged between the front electrode 2 and the back electrode 3. The stack 50 comprises the subcells 10,20,30 in a sequence from a side facing the light to a side facing away from the light as follows: 1) a first perovskite subcell 10 comprising a first perovskite photoactive layer 14 having a first band-gap, the first perovskite photoactive layer 14 comprising at least one perovskite absorber material; 2) a second perovskite subcell 20 comprising a second perovskite photoactive layer 24 having a second band-gap, the second perovskite photoactive layer 24 comprising at least one perovskite absorber material; and 3) an organic subcell 30 comprising an organic photoactive layer 34 absorbing in the red and near-infrared (NIR) spectral range and having a third band-gap, the organic photoactive layer 34 comprising at least one donor and at least one acceptor forming a donor/acceptor heterojunction. The first band-gap is larger than the second band-gap and the second band-gap is larger than the third band-gap.

The first band-gap of the first perovskite photoactive layer 14 is a band-gap of 1.85 eV. The second band-gap of the second perovskite photoactive layer 24 is a band-gap of 1.72 eV. The third band-gap of the organic photoactive layer 34 is a band-gap of 1.41 eV. The band-gaps are related to the absorption onset of the respective photoactive layer. The first band-gap of the first perovskite photoactive layer 14 is larger than the second band-gap of the second perovskite photoactive layer 24 by 130 meV; the second band-gap of the second perovskite photoactive layer 24 is larger than the third band-gap of the organic photoactive layer 34 by 310 meV, each related on the absorption onset of the respective photoactive layer.

In this exemplary embodiment, the first perovskite subcell 10, the second perovskite subcell 20, and the organic subcell 30 each are formed as a nip cell comprising an n-type layer 12,22,32, an intrinsic photoactive layer 14,24,34, and a p-type layer 16,26,36. In each subcell 10,20,30 the n-type layer 12,22,32 is at a side facing the light and the p-type layer 16,26,36 is at a side facing away from the light. The organic subcell 30 is formed as a BHJ cell. In an alternative embodiment the organic subcell can be formed as BHJ2, BHJ+, PHJ, or PHJ-cascade cell.

The p-type layer of a preceding subcell and the n-type layer of a following subcell starting from a side facing the light form together an interconnecting unit 60,70, e.g. p-type layer 16 of the first perovskite subcell 10 and n-type layer 22 of the second perovskite subcell 20, and p-type layer 26 of the second perovskite subcell 20 and n-type layer 32 of the organic subcell 30.

The p-type layers 16,26,36 of each subcell 10,20,30 each comprise an intrinsic p-type sublayer and a p-doped p-type sublayer having a band-gap of more than 2.5 eV and an ionization energy of at least 5.0 eV, and the n-type layers 12,22,32 of each subcell 10,20,30 each comprises an intrinsic n-type sublayer and a n-doped n-type sublayer comprising an electron transport material (ETM) and at least one n-dopant, wherein the n-type 12,22,32 layer has an electron affinity of less than 4.4 eV.

In an exemplary embodiment, the photovoltaic element 100 comprises a substrate 1, in particular a flexible substrate, e.g. a PET film, alternatively a rigid substrate 1, e.g. glass, with transparent ITO (indium-tin-oxide) as front electrode 2. In an alternative embodiment the front electrode 2 can be formed of a metal, in particular Al, Ag, Au or a combination thereof, another conductive oxide, in particular ZnO:Al, TiO₂ or SnO₂, or a conductive polymer, in particular PEDOT:PSS (Poly(3,4-ethylenedioxythiophene)-poly(sytrenesulfonate) or PANI (Polyanilin). A layer of fullerene C60 as n-type layer 12 (electron transport layer, ETL), a first perovskite photoactive layer 14 of an inorganic perovskite, e.g. CsPbI₂Br, and a p-type layer 16 of a wide gap hole transport material, e.g. TaTm, form the first perovskite subcell 10. In an alternative embodiment, the front electrode 2 is formed by a material having a work function of less than 4.5 eV, preferably by a TCO such as ZnO:Al or SnO₂ which directly forms an electron extracting contact to the first perovskite photoactive layer of the first perovskite subcell 10, wherein no n-type layer of the first perovskite subcell 10 is present. An interconnecting unit 60 is arranged between the first perovskite photoactive layer 14 and the second perovskite photoactive layer 24. The interconnecting unit 60, a pn-junction, is formed by the p-doped p-type layer 16, e.g. TaTm doped with NDP9, followed by an n-doped n-type layer 22, e.g. C60 doped with NDN45. The second subcell 20 is formed by a layer of fullerene C60 as n-type layer 22 (electron transport layer, ETL), the second perovskite photoactive layer 24 and a p-type layer 26, e.g. TaTm. An interconnecting unit 70 is arranged between the second perovskite photoactive layer 24 and the organic photoactive layer 34. The interconnecting unit 70, a pn-junction, is formed by the p-doped p-type layer 26, e.g. TaTm doped with NDP9, followed by an n-doped n-type layer 32, e.g. C60 doped with NDN45. The third subcell 30 is formed by a layer of fullerene C60 as n-type layer 32 (electron transport layer, ETL), the organic photoactive layer 34 and a p-type layer 36, e.g. TaTm. The organic photoactive layer 34 is formed by an organic donor material and acceptor material, either as a planar heterojunction (PHJ), wherein the acceptor layer is separated from the donor layer, or as a bulk heterojunction (BHJ), wherein the acceptor and the donor are blended.

### comparative example 1

In perovskite/organic tandem cells further increase of Jsc is hindered by the organic subcell, which prevents from exploiting the potential of perovskite subcells. Also increasing the thickness of the perovskite photoactive layer for increased photocurrent generation Jsc does not help to increase PCE, because in a perovskite/organic tandem cell Jsc is still limited by the organic subcell.

**Table 1**

| **layer** | **material** | **thickness [nm]** |
|---|---|---|
| back electrode | Al | 100 |
| metal oxide layer | MoOx | 25 |
| p-doped p-type layer | NHT049/NDP9 (6 wt.-%) | 40 |
| p-type layer | BF-DPB | 5 |
| organic photoactive layer | donor2 | 8 |
| organic photoactive layer | donor1 | 12 |
| n-type layer | C60 | 15 |
| n-doped n-type layer | C60:NDN45 (20 wt.-%) | 5 |
| p-doped p-type layer | NHT049/NDP9 (6 wt.-%) | 60 |
| p-doped p-type layer | BF-DPB /NDP9 (6 wt.-%) | 10 |
| p-type layer | BF-DPB | 15 |
| perovskite photoactive layer | CsPbI₂Br | 140 |
| passivation layer | PbCl₂ | 1 |
| n-type layer | C60 | 17 |
| doped n-type layer | C60:NDN45 (20 wt.-%) | 5 |
| front electrode | ITO | 100 |
| substrate | glass | |

| | | |
|---|---|---|
| ITO: indium tin oxide NDP9: commercial p-dopant of Novaled GmbH NDN45: commercial n-dopant of Novaled GmbH NHT049: kommerzieller Lochleiter der Novaled GmbH BF-DPB: N4,N4'-Bis (9,9-dimethyl-9H-fluoren-2-yl)-N4,N4'-diphenylbiphenyl-4,4'-diamine | | |

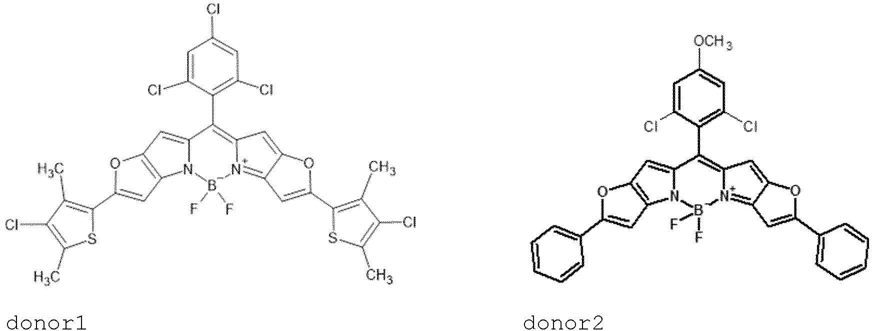

donor1 of the photoactive layer 34 has an absorption edge of 877 nm. donor2 of the photoactive layer 34 has an absorption edge of 791 nm.

In the photovoltaic element of comparative example 1, the fill factor FF is 72.0%, the open-circuit voltage Uoc is 2.05 V, and the short-circuit current Jsc is 9.66 mA/cm². The cell efficiency (PCE) of the photovoltaic element is 14.3%.

In an alternative embodiment BF-DPB is replaced by TaTm: N4,N4,N4",N4"-tetra([1,1'-biphenyl]-4-yl)-[1,1':4',1"-terphenyl]-4,4"-diamine.

### comparative example 2

**Table 2**

| **layer** | **material** | **thickness [nm]** |
|---|---|---|
| back electrode | Al | 100 |
| metal oxide layer | MoOx | 23 |
| p-doped p-type layer | NHT049/NDP9 (10 wt.-%) | 30 |
| p-doped p-type layer | BF-DPB /NDP9 (10 wt.-%) | 10 |
| p-type layer | BF-DPB | 15 |
| second perovskite photoactive layer | (Cs_{0.94}DMA_{0.06}) PbI₃ | 300 |
| passivation layer | PbCl₂ | 1 |
| n-type layer | C60 | 15 |
| n-doped n-type layer | C60:NDN45 (20 wt.-%) | 5 |
| n-doped interlayer | CN-HAT:TNATA (2 wt.-%) | |
| p-doped p-type layer | NHT049/NDP9 (10 wt.-%) | 30 |
| p-doped p-type layer | BF-DPB /NDP9 (10 wt.-%) | 10 |
| p-type layer | BF-DPB | 15 |
| first perovskite photoactive layer | CsPbI₂Br | 120 |
| passivation layer | PbCl₂ | 1 |
| n-type layer | C60 | 15 |
| doped n-type layer | C60:NDN45 (20 wt.-%) | 5 |
| front electrode 2 | ITO | 100 |
| substrate | glass | |

| | | |
|---|---|---|
| DMA: Dimethylammonium | | |

The n-dopant of the n-doped interlayer 75 is TNATA in a ratio of 2 wt.-%.

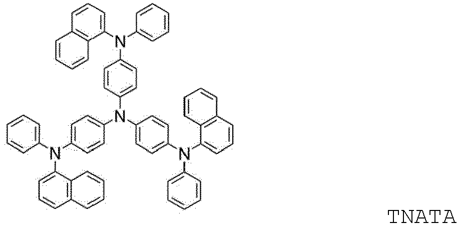

In the photovoltaic element of comparative example 2, the fill factor FF is 75.0%, the open-circuit voltage Uoc is 2.22 V, and the short-circuit current Jsc is 7.09 mA/cm². The cell efficiency of the photovoltaic element is 11.8%. The PCE is below the perovskite/organic tandem cell (comparative example 1) since the two perovskite subcells cover similar spectral ranges with a small redshift of 55 nm of the absorption edge when going from CsPbI₂Br to CsPbI₃ while the spectral range beyond 720 nm is not harvested.

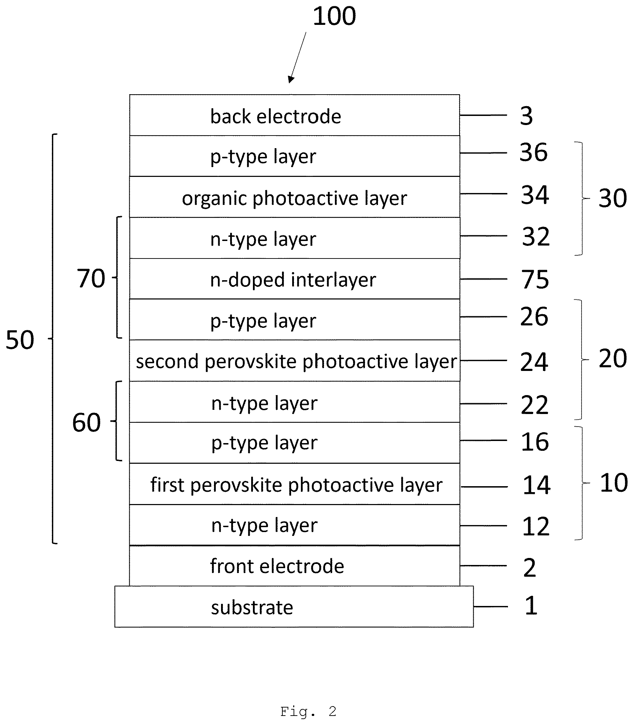

Fig. 2 shows a schematic illustration of an exemplary embodiment of a multi-junction photovoltaic element 100 comprising a first perovskite subcell 10, a second perovskite subcell 20 and an organic subcell 30 having an n-doped interlayer 75 between the second perovskite subcell 20 and the organic subcell 30 in cross-section.

In this exemplary embodiment the stack 50 is substantially the same compared to Fig. 1. An n-doped interlayer 75 is arranged between the p-type layer 26 of the second perovskite subcell 20 and the n-type layer 32 of the organic subcell 30. The n-doped interlayer 75 comprises a matrix material, which is an electron transport material (ETM), and a n-dopant, wherein the n-doped interlayer 75 has an electron affinity of more than 4.4 eV. The n-dopant of the n-doped interlayer 75 has a HOMO more negative than -4.6 eV. The p-type layer 26 of the second perovskite subcell 20, the n-type layer 32 of the organic subcell 30 and the n-doped interlayer between are forming the interconnecting unit 70 for interconnecting the two subcells 20,30.

In this exemplary embodiment the interconnecting unit 70 comprises in sequence the following layers: a) a doped or non-doped p-type layer 26 having a band-gap of more than 2.5 eV, wherein the p-type layer 26 has an ionization energy of at least 5.0 eV; b) an n-doped interlayer 75 comprising a matrix material and at least one n-dopant, wherein the n-doped interlayer 75 has an electron affinity of more than 4.4 eV and the n-dopant in a ratio of 20 wt-% of the n-doped interlayer 75 has a HOMO more negative than -4.6 eV; and c) a doped n-type layer 32 comprising an electron transport material (ETM) and at least one n-dopant, wherein the n-type layer 32 has an electron affinity of less than 4.4 eV.

In this exemplary embodiment the matrix material of the n-doped interlayer 65,75 is Dipyrazino[2,3-f:2',3'-h]quinoxaline-2,3,6,7,10,11-hexacarbonitril (CN-HAT). More generally the matrix material of the n-doped interlayer 65,75 is a chemical compound of formula I 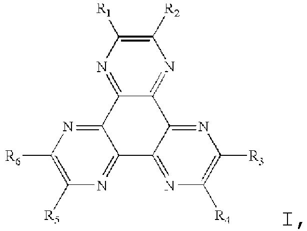 wherein R₁ to R₆ is H or a substituent selected from the group consisting of halogen, -CN, -NO₂, -SO₂R, -SOR, -CF₃,-COOR), -CONHR, -CONRR'), non-substituted or substituted aryl, non-substituted or substituted heteroaryl, and non-substituted or substituted alkyl, wherein R and R' are a non-substituted or substituted alkyl or aryl, or wherein R₁ and R₂, R₃ and R₄, or R₅ and R₆ together form a ring-structure, wherein the ring-structure is an aromatic ring, a heteroaromatic ring, or an aliphatic ring, which ring-structure can be non-substituted or substituted.

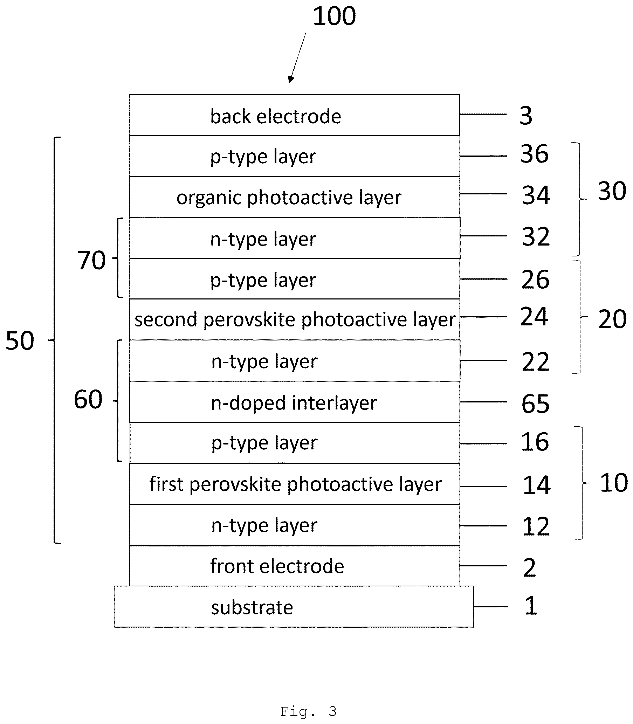

Fig. 3 shows a schematic illustration of an exemplary embodiment of a multi-junction photovoltaic element 100 comprising a first perovskite subcell 10, a second perovskite subcell 20 and an organic subcell 30 having a n-doped interlayer 65 between the perovskite subcells 10,20 in cross-section.

In this exemplary embodiment the stack 50 is substantially the same compared to Fig. 1. An n-doped interlayer 65 is arranged between the p-type layer 16 of the first perovskite subcell 10 and the n-type layer 22 of the second perovskite subcell 20. The p-type layer 16 of the first perovskite subcell 10, the n-type layer 22 of the second perovskite subcell 20, and the n-doped interlayer 65 in between are forming the interconnecting unit 60. The n-doped interlayer 65 comprises a matrix material, which is an electron transport material (ETM), and a n-dopant, wherein the n-doped interlayer 65 has an electron affinity of more than 4.4 eV, preferably more than 4.8 eV. The n-dopant of the n-doped interlayer 65 has a HOMO less negative than -5.4 eV, preferably less negative than -5.1 eV.

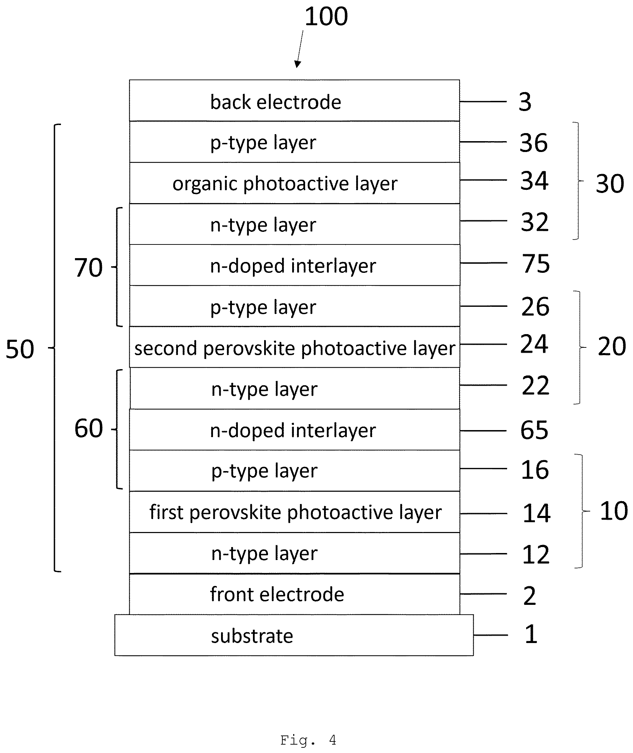

Fig. 4 shows a schematic illustration of an exemplary embodiment of a multi-junction photovoltaic element 100 comprising a first perovskite subcell 10, a second perovskite subcell 20 and an organic subcell 30 having n-doped interlayers 65,75 between the subcells 10,20,30 in cross-section.

In this exemplary embodiment the stack 50 is substantially the same compared to Fig. 1. In the interconnecting units 60 between the first perovskite subcell 10 and the second perovskite subcell 20 and in the interconnecting unit 70 between the second perovskite subcell 20 and the organic subcell 30 in each case an n-doped interlayer 65,75 is arranged between the p-type layer 16 of the first perovskite subcell 10 and the n-tpe layer 22 of the second perovskite subcell 20 and between the p-type layer 26 of the second perovskite subcell 20 and the n-type layer 32 of the organic subcell 30. The n-doped interlayers 65,75 each comprises a matrix material, which is an electron transport material (ETM), and a n-dopant, wherein the n-doped interlayer 75 has an electron affinity of more than 4.4 eV. The n-dopant of the n-doped interlayer 75 has a HOMO less negative than -5.1 eV.

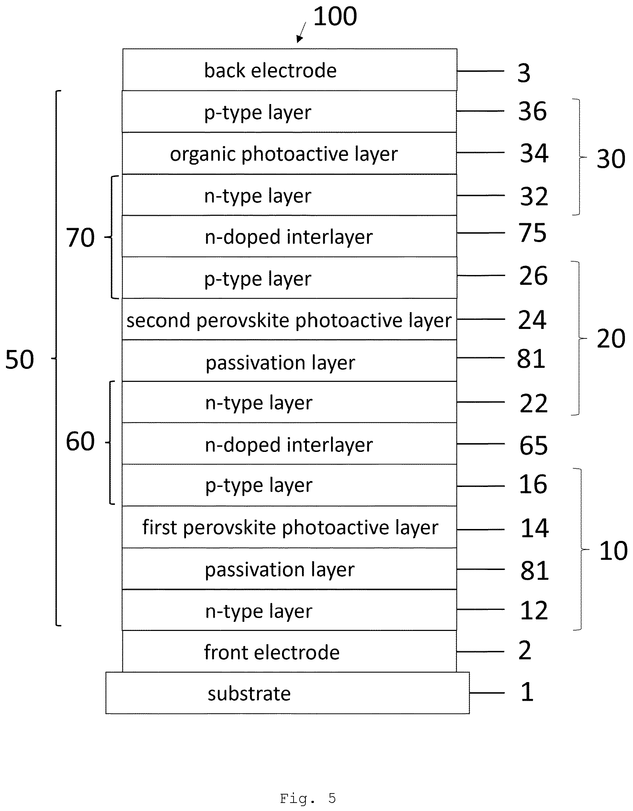

Fig. 5 shows a schematic illustration of an exemplary embodiment of a multi-junction photovoltaic element 100 comprising a first perovskite subcell 10, a second perovskite subcell 20 and an organic subcell 30 having n-doped interlayers 65,75 between the subcells 10,20,30 and a passivation layer 81 at each perovskite subcell 10,20 in cross-section.

In this exemplary embodiment the stack 50 is substantially the same compared to Fig. 4, wherein passivation layers 81 are arranged to improve the durability of the stack 50. The passivation layers 81 are arranged on the side facing the light at the first perovskite photoactive layer 14 and on the side facing the light at the second perovskite photoactive layer 24. In this exemplary embodiment the passivation layers 81 are directly arranged at the first perovskite photoactive layer 14 and at the second perovskite photoactive layer 24. The passivation layers 81 are made of PbCl₂ and have a layer thickness of 1 nm.

### working example 1

The structure of the photovoltaic element 100 including stack 50 of working example 1 is shown in Table 3.

**Table 3**

| **Layer** | **material** | **thickness [nm]** |
|---|---|---|
| back electrode 3 | Al | 100 |
| metal oxide layer | MoOx | 15 |
| p-doped p-type layer 36 | NHT049/NDP9 (6 wt.-%) | 50 |
| p-type layer 36 | BF-DPB | 5 |
| organic photoactive layer 34 | donor1 | 10 |
| n-type layer 32 | C60 | 15 |
| n-doped n-type layer 32 | C60:NDN45 (20 wt.-%) | 5 |
| p-doped p-type layer 26 | NHT049/NDP9 (6 wt.-%) | 70 |
| p-doped p-type layer 26 | BF-DPB /NDP9 (6 wt.-%) | 10 |
| p-type layer 26 | BF-DPB | 15 |
| second perovskite photoactive layer 24 | CsPbI₃:PbCl₂ (99:1) | 200 |
| passivation layer 81 | PbCl₂ | 1 |
| n-type layer 22 | C60 | 15 |
| n-doped n-type layer 22 | C60:NDN45 (20 wt.-%) | 5 |
| p-doped p-type layer 16 | NHT049/NDP9 (6 wt.-%) | 50 |
| p-doped p-type layer 16 | BF-DPB /NDP9 (6 wt.-%) | 20 |
| p-type layer 16 | BF-DPB | 15 |
| first perovskite photoactive layer 14 | CsPbI₂Br | 100 |
| passivation layer 81 | PbCl₂ | 1 |
| n-type layer 12 | C60 | 15 |
| n-doped n-type layer 12 | C60:NDN45 (20 wt.-%) | 5 |
| front electrode 2 | ITO | 100 |
| substrate 1 | glass | |

| | | |
|---|---|---|
| ITO: indium tin oxide NDP9: commercial p-dopant of Novaled GmbH NDN45: commercial n-dopant of Novaled GmbH NHT049: kommerzieller Lochleiter der Novaled GmbH BF-DPB: N4,N4'-Bis (9,9-dimethyl-9H-fluoren-2-yl)-N4,N4'-diphenylbiphenyl-4,4'-diamine | | |

In an alternative embodiment in the p-doped p-type layers 16,26 BF-DPB is replaced by TaTm: N4,N4,N4'',N4''-tetra([1,1'-biphenyl]-4-yl)-[1,1':4',1"-terphenyl]-4,4"-diamine.

In working example 1 the perovskite absorber material in the first perovskite photoactive layer 14 is CsPbI₂Br (CsPb (IₓBr₍₁₋ₓ₎)₃ with x=0.67), and the perovskite absorber material in the second perovskite photoactive layer 24 is CsPbI₃ (CsPb (IₓBr₍₁₋ₓ₎)₃ with x= 1) which both are all-inorganic perovskites. The perovskite absorber material of the second perovskite photoactive layer 24 is doped by PbCl₂ in a ratio of 1 wt.-%. The first perovskite photoactive layer 14 and the second perovskite photoactive layer 24 do not comprise organic cations. The first perovskite photoactive layer 14 is an inorganic layer and the second perovskite photoactive layer 24 is an inorganic layer. The thickness of the first perovskite photoactive layer 14 is 100 nm, the thickness of the second perovskite photoactive layer 24 is 200 nm, and the thickness of the organic photoactive layer 34 is 10 nm.

In working example 1 the organic photoactive layer 34 is formed as PHJ (planar-heterojunction) having an acceptor layer of C60 (15 nm), which is also n-type-layer 32, and a donor layer of donor1 of 10 nm. Alternatively, the organic photoactive layer 34 can by formed as BHJ cell comprising a blend of the donor and the acceptor, e.g. donor1 and fullerene C60. donor1 of the organic photoactive layer 34 is a BODIPY compound. donor1 of the photoactive layer 34 has an absorption edge of 877 nm. In an alternative embodiment the donor of the organic photoactive layer 34 is an A-D-A compound and the acceptor of the organic photoactive layer 34 is fullerene C60.

The first perovskite photoactive layer 14 is part of a first subcell 10, the second perovskite photoactive layer 24 is part of a second subcell 20, and the organic photoactive layer 34 is part of the third subcell 30. The subcells 10,20,30 are formed as a nip cell each comprising a n-type layer 12,22,32, a p-type layer 16,26,36 and the photoactive layer 14,24,34 in between. The n-type layers 12,22,32 each are formed by an non-doped n-type sublayer and an n-doped n-type sublayer, and the p-type layers 16,26,36 each are formed by an non-doped p-type sublayer and a p-doped p-type sublayer. Between the photoactive layers 14,24,34 interconnecting units 60,70 are arranged each comprising the n-type layer 12,22,32 and the p-type layers 16,26,36, respectively. The p-type layer 16 of the interconnecting unit 60 is facing the first perovskite photoactive layer 14 and the n-type layer 22 of the interconnecting unit 60 is facing the second perovskite photoactive layer 24. The p-type layer 26 of the interconnecting unit 70 is facing the second perovskite photoactive layer 24 and the n-type layer 32 of the interconnecting unit 70 is facing the organic photoactive layer 34.

The stack 50, in particular individual layers, and front electrode 2 and back electrode 3 of the photovoltaic element 100, can be applied by vacuum deposition of the compounds. Substrate 1 can be a flexible substrate, e.g. a film from PET. The layers can be deposited in a roll-to-roll process.

### Preparation of the photovoltaic element 100 of working example 1:

Stack 50 including subcells 10,20,30 of the photovoltaic element 100 was manufactured by thermal evaporation processes in chambers kept under high vacuum, typically at/below 10⁻⁶ mbar. Vacuum deposition of the individual layers of the stack 50 as well as back electrode 3 was used to apply the individual layers of stack 50. Substrate 1 with the front electrode 2 was provided. The layers of stack 50 are formed step by step one after the other.

Subcell 10 comprising the first perovskite photoactive layer 14, and interconnecting unit 60: For subcell 10 C60 and NDN45 in a ratio of 20 wt.-% were co-evaporated (5 nm) and a layer of C60 (15 nm) was deposited at a deposition rate of 0.2 to 0.3 Å/s on an ITO (100 nm) layered glass substrate patterned with an active area of 6.4 mm² to create an n-type layer 12 as electron transport layer (ETL). A passivation layer 81 of PbCl₂ (1 nm) was deposited at a deposition rate of 0.2 to 0.3 Å/s before an all-inorganic CsPbI₂Br layer was subsequently formed on the passivation layer 81 by co-evaporating two precursors, a first precursor CsBr and a second precursor PbI₂, at deposition rates of 0.2 Å/s and 0.30 Å/s, respectively. The thickness of the first perovskite photoactive layer 14 in a layer thickness of 100 nm. A layer of BF-DPB (15 nm) was applied on the top of the first perovskite photoactive layer 14 as non-doped p-type layer followed by co-evaporating BF-DPB and NDP as dopant (6 wt.-%) as p-doped p-type layer at a deposition rate of 0.3 Å/s to form a p-type layer 16 as hole transport layer (HTL). Subsequently, a n-doped n-type layer was applied by co-evaporating C60 as HTM and NDN45 as n-dopant in a ratio of 20 wt.-% (5 nm) and a non-doped n-type layer of C60 at a deposition rate of 0.3 Å/s to form a n-type layer 22. A passivation layer of PbCl₂ (1 nm) was deposited at a deposition rate of 0.2 to 0.3 Å/s before the second perovskite photoactive layer 24 is applied by co-evaporating two precursors, a first precursor CsBr and a second precursor PbI₂, and PBCl₂ in a ratio of 1 wt.-% as dopant at deposition rates of 0.2 Å/s and 0.30 Å/s. Again, a layer of BF-DPB (15 nm) was applied on the top of the second perovskite photoactive layer 24 as non-doped p-type layer followed by co-evaporating BF-DPB and NDP (6 wt.-%) as p-doped p-type layer at a deposition rate of 0.3 Å/s to form a p-type layer 26 as hole transport layer (HTL). Subsequently, a n-doped n-type layer was applied by co-evaporating C60 as HTM and NDN45 as n-dopant in a ratio of 20 wt.-% (5 nm) and a non-doped n-type layer of C60 at a deposition rate of 0.3 Å/s to form a n-type layer 32.

The substrate 1 with the applied subcells 10,20 was transferred to another vacuum chamber to prepare the third subcell 30 comprising the organic photoactive layer 34. The organic photoactive layer 34 was applied on the n-type layer 32. The organic photoactive layer 34 is formed as PHJ (planar heterojunction) cell or as BHJ (bulk heterojunction) cell. In case of the PHJ cell (working example 1, Table 3) the intrinsic n-type layer 32 is used as acceptor layer or an additional layer of C60 was deposited as acceptor layer with a deposition rate of 0.2 Å/s to construct the acceptor layer of the PHJ cell. In working example 1 the n-type layer 32 and the acceptor layer of the organic photoactive layer 34 are of the same material. An organic absorber layer of donor1 (10 nm) was then applied on the acceptor layer at a deposition rate of 0.3 Å/s to construct a donor layer of the organic photoactive layer 34. Alternatively in case of the BHJ cell (working example 2, Table 4) to construct the organic photoactive layer 34 can be formed by co-evaporating donor1 as donor and C60 as acceptor (1:1) at a deposition rate of 0.3 Å/s. In both working examples 1 and 2 the donors, donor1 and donor3, of the organic photoactive layer 34 are small molecules having a defined molecular structure and a molar mass of 100 g/mol to 1000 g/mol.

To facilitate the hole transport towards the back electrode 3 an non-doped p-type layer of BF-DPB (5 nm) followed by co-evaporating a p-doped p-type layer of NHT049 doped with NDP9 6 wt.-% (50 nm) was applied at a deposition rate of 0.2 Å/s to form a p-type layer 36. Additionally, a metal oxide layer of MoOx was deposited on the stack 50 (15 nm). Finally, a layer of Al (100 nm) was deposited at a deposition rate of 1.0 Å/s as back electrode 3. The temperature of the substrate 1 during the process was 30°C. Deposition of the layers at higher deposition rate or lower deposition rate is possible, preferably in the range of 0.1 to 10 Å/s.

The current-voltage curve was measured using a Keithley 2400 source measure unit under AM1.5 sun simulator (AM = air mass; AM=1.5, radiant power 1000 W/m²).

In the photovoltaic element 100 of working example 1, the fill factor FF is 73.2%, the open-circuit voltage Uoc is 3.07 V, and the short-circuit current Jsc is 6.75 mA/cm². The cell efficiency (PCE) of the photovoltaic element 100 is 15.2%. In contrast to the organic/perovskite tandem cell (comparison example 1) PCE is not limited by the organic subcell.

The energy levels of materials used in working examples 1 and 2 are summarized in the following table:

| **material** | **LUMO [eV]** | **HOMO [eV]** |
|---|---|---|
| | **electron affinity** | **ionization energy** |
| BF-DPB | -2.3 | -5.3 |
| TaTm | -2.35 | -5.4 |
| CNHAT | -5.1 | -7.5 |
| m-MTDATA | -2.0 | -5.1 |
| NDP9 | -5.4 | |
| C60 | -4.0 | -5.6 |
| TNATA | -2.2 | -5.0 |
| NDN45 | -2.6 | -4.5 |

### working example 2

The structure of the photovoltaic element 100 including stack 50 of working example 2 is shown in Table 4:

**Table 4**

| **layer** | **Material** | **thickness [nm]** |
|---|---|---|
| back electrode 3 | Al | 100 |
| metal oxide layer | MoOx | 15 |
| p-doped p-type layer 36 | NHT049/NDP9 (6 wt.-%) | 50 |
| p-type layer 36 | BF-DPB | 5 |
| organic photoactive layer 34 | donor3/C60 (1:1) | 10 |
| n-type layer 32 | C60 | 15 |
| n-doped n-type layer 32 | C60:NDN45 (20 wt.-%) | 5 |
| n-doped interlayer 75 | CN-HAT:m-MTDATA (2 wt.-%) | 40 |
| p-doped p-type layer 26 | NHT049/NDP9 (6 wt.-%) | 20 |
| p-doped p-type layer 26 | BF-DPB /NDP9 (6 wt.-%) | 20 |
| p-type layer 26 | BF-DPB | 15 |
| second perovskite photoactive layer 24 | (Cs_{0.94}DMA_{0.06})PbI₃ | 200 |
| passivation layer 81 | PbCl₂ | 1 |
| n-type layer 22 | C60 | 17 |
| doped n-type layer 22 | C60:NDN45 (20 wt.-%) | 5 |
| n-doped interlayer 65 | CN-HAT:m-MTDATA (2 wt.-%) | 40 |
| p-doped p-type layer 16 | NHT049/NDP9 (6 wt.-%) | 15 |
| p-doped p-type layer 16 | BF-DPB /NDP9 (6 wt.-%) | 15 |
| p-type layer 16 | BF-DPB | 15 |
| first perovskite photoactive layer 14 | CsPbI₂Br | 120 |
| passivation layer 81 | PbCl₂ | 1 |
| n-type layer 12 | C60 | 17 |
| n-doped n-type layer 12 | C60:NDN45 (20 wt.-%) | 5 |
| front electrode 2 | ITO | 100 |
| Substrate 1 | glass | |

| | | |
|---|---|---|
| DMA: Dimethylammonium | | |

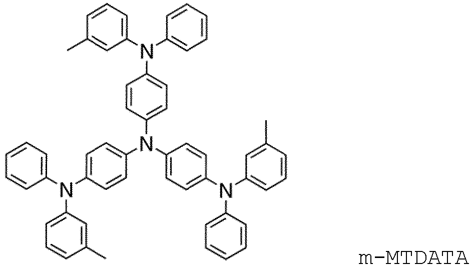

In an alternative embodiment in the n-doped interlayers 65,75 m-MTDATA: 4,4',4' '-Tris(N-3-methylphenyl-N-phenyl-amino)-triphenylamine is replaced by TNATA. 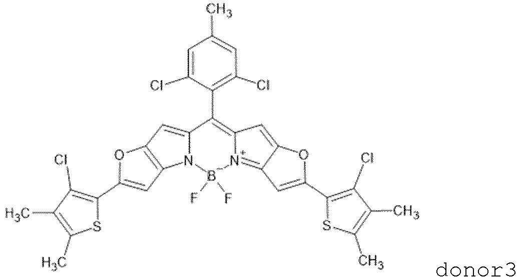 donor3 of the photoactive layer 34 has an absorption edge of 901 nm.

In working example 2 the stack 50 is substantially the same compared working example 1, wherein in the second perovskite photoactive layer 24 (Cs_{0.94}DMA_{0.06})PbI₃ is used instead of CsPbI₃, and donor3 is used instead of donor1 in the organic photoactive layer 34. The organic photoactive layer 34 is formed as BHJ (bulkheterojunction) by a mixture of C60 and donor2 in a ratio of 1:1 by weight. Between the p-type layer 16,26 and the n-type layer 22,32 of the interconnecting units 60,70 in each case an n-doped interlayer 65,75 is arranged. The p-type layers 16,26 of the interconnecting units 60,70 each comprises an non-doped p-type sublayer and a p-doped p-type sublayer comprising the matrix material BF-DPB (ionization energy of 5.4 eV) and the p-dotand NDP9 (LUMO of 5.4 eV) in a ratio of 6 wt.%. The n-type layers 22,32 of the interconnecting units 60,70 each comprises an non-doped n-type sublayer and a n-doped n-type sublayer comprising C60 (electron affinity of 4.0 eV) as matrix material and the n-dopant NDN45 (HOMO of -4.56 eV) in a ratio of 20 wt.-%. The n-doped interlayers 65,75 comprises CN-HAT (electron affinity 5.0 eV) as matrix material and m-MTDATA as n-dopant in a ratio of 2 wt.-% (ionization energy 5.0 eV).

In working example 2 the perovskite absorber material in the first perovskite photoactive layer 14 is CsPbI₂Br (CsPb (IₓBr₍₁₋ₓ₎)₃ with x=0.67), and the perovskite absorber material in the second perovskite photoactive layer 24 is (Cs_{0.94}DMA_{0.06})PbI₃.

In the photovoltaic element of working example 2, the fill factor FF is 72.0%, the open-circuit voltage Uoc is 3.1 V, and the short-circuit current Jsc is 6.85 mA/cm². The cell efficiency (PCE) of the photovoltaic element is 15.3%. In contrast to the organic/perovskite tandem cell (comparative example 1) PCE is not limited by the organic subcell and the the efficiency (PCE) was improved.

## Claims

1. A multi-junction photovoltaic element (100) with at least three subcells (10,20,30), comprising a front electrode (2), a back electrode (3), and a stack (50) arranged between the front electrode (2) and the back electrode (3), the stack (50) comprising the subcells (10,20,30) in a sequence from a side facing the light to a side facing away from the light as follows:
a first perovskite subcell (10) comprising a first perovskite photoactive layer (14) having a first band-gap, the first perovskite photoactive layer (14) comprising at least one perovskite absorber material;
a second perovskite subcell (20) comprising a second perovskite photoactive layer (24) having a second band-gap, the second perovskite photoactive layer (24) comprising at least one perovskite absorber material; and
an organic subcell (30) comprising an organic photoactive layer (34) absorbing in the red and near-infrared (NIR) spectral range and having a third band-gap, the organic photoactive layer (34) comprising at least one donor and at least one acceptor forming a donor/acceptor heterojunction,
wherein the first band-gap is larger than the second band-gap and the second band-gap is larger than the third band-gap.

2. The multi-junction photovoltaic element (100) according to claim 1, wherein the organic photoactive layer (34) having an absorption edge of at least 700 nm, preferably of at least 750 nm, preferably of at least 780 nm, or preferably of at least 800 nm.

3. The multi-junction photovoltaic element (100) according to claim 1 or 2, wherein the first band-gap of the first perovskite photoactive layer (14) is larger than the second band-gap of the second perovskite photoactive layer (24) by at least 100 meV, preferably by at least 130 meV, or preferably by at least 150 meV, and/or the second band-gap of the second perovskite photoactive layer (24) is larger than the third band-gap of the organic photoactive layer (34) by at least 200 meV, preferably by at least 300 meV, each related on the absorption onset of the respective photoactive layer.

4. The multi-junction photovoltaic element (100) according to any of the preceding claims, wherein the first band-gap of the first perovskite photoactive layer (14) is a band-gap of at least 1.75 eV, preferably of at least 1.78 eV, preferably of at least 1.80 eV, or a band-gap in the range of 1.72 eV to 3.0 eV, preferably a band-gap in the range of 1.80 eV to 3.0 eV, and wherein the second band-gap of the second perovskite photoactive layer (24) is a band-gap of less than 1.75 eV, preferably of less than 1.72 eV, or preferably of less than 1.70 eV, or a band-gap in the range of 1.5 eV to 1.75 eV, preferably a band-gap in the range of 1.6 eV to 1.70 eV, and wherein the third band-gap of the organic photoactive layer (34) is a band-gap of less than 1.50 eV, preferably of less than 1.40 eV, or preferably of less than 1.30 eV, or a band-gap in the range of 0.7 eV to 1.6 eV, preferably a band-gap in the range of 0.7 eV to 1.5 eV, each related on the absorption onset of the respective photoactive layer.

5. The multi-junction photovoltaic element (100) according to any of the preceding claims, wherein the first perovskite subcell (10), the second perovskite subcell (20), and/or the organic subcell (30) each are formed as a nip cell comprising an n-type layer (12,22,32), an intrinsic photoactive layer (14,24,34), and a p-type layer (16,26,36), wherein in each subcell (10,20,30) the n-type layer (12,22,32) is at a side facing the light and the p-type layer (16,26,36) is at a side facing away from the light, or wherein the first perovskite subcell (10) is formed as an ip cell comprising an intrinsic photoactive layer (14) and a p-type layer (16), wherein the intrinsic photoactive layer (14) is at a side facing the light and the p-type layer (16) is at a side facing away from the light, and the second perovskite subcell (20) and/or the organic subcell (30) each are formed as a nip cell comprising an n-type layer (22,32), an intrinsic photoactive layer (24,34), and a p-type layer (26,36), wherein in each subcell (20,30) the n-type layer (22,32) is at a side facing the light and the p-type (26,36) layer is at a side facing away from the light.

6. The multi-junction photovoltaic element (100) according to any of the preceding claims, wherein a passivation layer (81) is arranged at a side facing the light of the first perovskite photoactive layer (14) and/or at a side facing the light of the second perovskite photoactive layer (24), wherein preferably the passivation layer (81) is a layer of PbCl₂ or SnO₂, and/or having a layer thickness of 1 nm to 10 nm, or preferably of 1 nm to 5 nm.

7. The multi-junction photovoltaic element (100) according to any of the preceding claims, wherein the first perovskite photoactive layer (14) and/or the second perovskite photoactive layer (24) comprise organic cations at maximum of 20 wt.-%, preferably at maximum of 10 wt.-%, more preferably do not comprise organic cations, preferably the first perovskite photoactive layer (14) comprises an inorganic layer as matrix material and/or the second perovskite photoactive layer (24) comprises an inorganic layer as matrix material.

8. The multi-junction photovoltaic element (100) according to any of the preceding claims, wherein the perovskite absorber material of the first perovskite photoactive layer (14) and/or the second perovskite photoactive layer (24) is independently an inorganic perovskite, preferably a three-dimensional halide perovskite, a double perovskite, or a combination thereof, wherein preferably the three-dimensional halide perovskite having a formula ABX₃, wherein A is selected from Cs, Na, K, Rb, or a combination thereof; B is selected from Pb, Sn, Ge, Cu, Fe, Ga, Eu, Sr, Ti, Mn, Bi, Zn, Mg, Ca, Ba, Y, Yb, Co, In, Sb, Bi, Ag, Ni, Ho, Er, Tb, Sm, La, or a combination thereof; and X is selected from F, Cl, Br, I, or a combination thereof; and wherein preferably the double perovskite having a formula A₂BCX₆, wherein A is selected from Cs, Rb, or combination thereof; B is selected from Cu, Ag, Hg, Au, or a combination thereof; C is selected from Sb, Bi, In or a combination thereof; and X is selected from F, Cl, Br, I, or a combination thereof.

9. The multi-junction photovoltaic element (100) according to any of the preceding claims, wherein the at least one perovskite absorber material in the first perovskite photoactive layer (14) is Cs_{y}Pb(IₓBr₍₁₋ₓ₎)₃ with x<0.75, preferably x<0.5, or preferably x<0.4, or in the range of 0.1 < x < 0.75, preferably in the range of 0.4 < x < 0.7, and y in the range of 0.9 < y < 1.1, and the at least one perovskite absorber material in the second perovskite photoactive layer (24) is Cs_{y}Pb(IₓBr₍₁₋ₓ₎)₃ with x>0.9, preferably with x>0.94, or in the range of 1.0 > x >0.9, preferably in the range of 1.0 > x >0.94, and with y in the range of 0.9 < y < 1.1.

10. The multi-junction photovoltaic element (100) according to claim 8 or 9, wherein the perovskite absorber material of the first perovskite photoactive layer (14) and/or the perovskite absorber material of the second perovskite photoactive layer (24) is doped by PbCl₂, preferably in a ratio of 0.1 to 3 wt.-%, preferably 0.5 to 3 wt.-%, preferably 0.1 to 2 wt.-%, or preferably 0.5 to 2 wt.-%, or wherein the perovskite absorber material of the first perovskite photoactive layer (14) and/or the perovskite absorber material of the second perovskite photoactive layer (24) is doped by an organic salt, preferably guanidinium halide (GAX), biguanidinium halide (BGAX), or metformine halide (MFX) with X selected from I, Br, or Cl, preferably in a ratio of 0.1 to 5 wt.-%, preferably 0.5 to 4 wt.-%, preferably 0.5 to 3 wt.-%, or preferably 1 to 3 wt.-%.

11. The multi-junction photovoltaic element (100) according to any of the preceding claims, wherein the thickness of the first perovskite photoactive layer (14) is 50 nm to 1000 nm, preferably 50 nm to 500 nm, preferably 50 nm to 300 nm, or preferably 100 nm to 400 nm, and/or the thickness of the second perovskite photoactive layer (24) is 100 nm to 1000 nm, preferably 100 nm to 500 nm, preferably 100 nm to 300 nm, or preferably 200 nm to 400 nm, and/or the thickness of the organic photoactive layer (34) is 5 nm to 50 nm, preferably 5 nm to 30 nm, or preferably 10 nm to 30 nm.

12. The multi-junction photovoltaic element (100) according to any of the preceding claims, wherein the at least one donor of the organic photoactive layer (34) is an A-D-A compound and/or a BODIPY compound, and/or the at least one acceptor of the organic photoactive layer (34) is a fullerene or fullerene derivate, preferably fullerene C60.

13. The multi-junction photovoltaic element (100) according to any of the preceding claims, wherein the p-type layer (16,26,36) of each subcell (10,20,30) is a doped and/or non-doped p-type layer having a band-gap of more than 2.5 eV, wherein the p-type layer (16,26,36) has an ionization energy of at least 5.0 eV, and wherein the n-type layer (12,22,32) of each subcell (10,20,30) is a doped and/or non-doped n-type layer comprising an electron transport material (ETM) and at least one n-dopant, wherein the n-type (12,22,32) layer has an electron affinity of less than 4.4 eV.

14. The multi-junction photovoltaic element (100) according to claim 13, wherein between the first perovskite subcell (10) and the second perovskite subcell (20), and/or between the second perovskite subcell (20) and the organic subcell (30) an n-doped interlayer (65,75) is arranged, the n-doped interlayer (65,75) comprising a matrix material, preferably an electron transport material (ETM), and at least one n-dopant, wherein the n-doped interlayer (65,75) has an electron affinity of more than 4.4 eV, preferably the n-dopant of the n-doped interlayer (65,75) has a HOMO more negative than -4.6 eV, and wherein the ratio of the at least one dopant is 1 to 30 vol.-%.

15. The multi-junction photovoltaic element (100) according to claim 14, wherein the matrix material of the n-doped interlayer (65,75) is a chemical compound of formula I 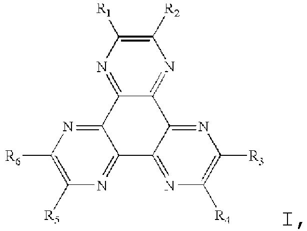 wherein R₁ to R₆ is H or a substituent selected from the group consisting of halogen, -CN, -NO₂, -SO₂R, -SOR, -CF₃,-COOR), -CONHR, -CONRR'), non-substituted or substituted aryl, non-substituted or substituted heteroaryl, and non-substituted or substituted alkyl, wherein R and R' are a non-substituted or substituted alkyl or aryl, or wherein R₁ and R₂, R₃ and R₄, or R₅ and R₆ together form a ring-structure, wherein the ring-structure is an aromatic ring, a heteroaromatic ring, or an aliphatic ring, which ring-structure can be non-substituted or substituted.
